(19)

**Europäisches Patentamt**
**European Patent Office**
**Office européen des brevets**

(11) **EP 3 951 404 A1**

(12) **EUROPEAN PATENT APPLICATION**

(43) Date of publication:
**09.02.2022  Bulletin 2022/06**

(51) International Patent Classification (IPC):
**G01R 15/24** (2006.01)

(21) Application number: **20189644.6**

(52) Cooperative Patent Classification (CPC):
**G01R 15/24; G01R 15/241**

(22) Date of filing: **05.08.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Hitachi Energy Switzerland AG**
**5400 Baden (CH)**

(72) Inventor: **BOHNERT, Klaus**
**5452 Oberrohrdorf (CH)**

(74) Representative: **Vossius & Partner**
**Patentanwälte Rechtsanwälte mbB**
**Siebertstrasse 3**
**81675 München (DE)**

(54) **FIBER-OPTICAL VOLTAGE SENSOR**

(57)     The present invention relates to a fiber-optic sensor for measuring an optical phase shift between a fundamental fiber mode and a first higher order mode of an optical sensing fiber (200), comprising an integrated-optic waveguide beam splitter (OW) having a first port at a first side and N second ports at a second side, the first and second side being preferably opposite to each other, N being a positive integer N ≥ 2, and the integrated-optic waveguide beam splitter having a splitter plane; M first polarizing elements (PE1,PE2,... PEM), M being a positive integer M ≥ 2, coupled to the second side of the integrated-optic waveguide beam splitter; a birefringent optical element (R) arranged between at least one of the M first polarizing elements and at least one port of the N ports of the second side of the 1 x N integrated-optic waveguide beam splitter; and a polarization-maintaining optical fiber (300), a second polarizing element (500), the optical sensing fiber (200), and a reflector (600).

FIG. 12

**Description**

FIELD OF THE INVENTION

The invention relates to a fiber-optical voltage sensor for an electric power transmission system.

BACKGROUND OF THE INVENTION

Optical electric field and voltage sensors commonly make use of an electro-optic effect (Pockels effect) in an electro-optic crystal such as BGO ($Bi_4Ge_3O_{12}$). The sensors, which are configured to where the full power line voltage (up to several 100 kV) is applied along the longitudinal axis of a cylinder-shaped crystal. The crystal length may be in a range between 100 and 300 mm.

In order to prevent dielectric breakdown due to the high electric field strengths in the crystal's vicinity, adequate electric insulation measures are required. For example, the sensor may reside in a hollow-core insulator filled with pressurized Sulfur hexafluoride ($SF_6$) gas or in a solid-state insulator comprising a body of resin-impregnated paper or resin-impregnated fiber with embedded cylinder-shaped metal foils for field steering. Another design concept derives the voltage from three local electro-optic field sensors arranged along the axis of a nitrogen gas filled hollow insulator column. The insulator incorporates measures to shield the sensors from the fields of adjacent electric phases.

The above insulation methods have one thing in common that they are expensive and result in a large transformer size similar to the size of conventional inductive or capacitive voltage transformers.

In addition, a voltage sensor may also measure the voltage by integrating the electric field between ground and high voltage by a series of piezo-electric quartz crystals. An optical fiber senses the piezo-electric deformations of the crystals. This kind of voltage sensor may employ an interrogation technique related to white light interferometry. Furthermore, an alternative interrogation technique based on non-reciprocal phase modulation as used in fiber-optic gyroscopes and current sensors may be adopted. However, a drawback of both interrogation techniques is that a polarization-maintaining fiber between the sensor head and the interrogator (opto-electronics module) is required.

DESCRIPTION OF THE INVENTION

These and other objectives are achieved by a voltage sensing structure according to the independent claims. Preferred embodiments are evident from the dependent patent claims.

The present invention relates to a fiber-optic sensor for measuring an optical phase shift $\phi$ between two orthogonal polarization modes of a polarization-maintaining optical sensing fiber, comprising an integrated-optic waveguide beam splitter having a first port at a first side and N second ports at a second side, the first and second side being preferably opposite to each other, N being a positive integer N $\geq$ 2, and the integrated-optic waveguide beam splitter having a splitter plane; M polarizing elements, M being a positive integer M $\geq$ 2, coupled to the second side of the integrated-optic waveguide beam splitter; a birefringent optical element arranged between at least one of the M polarizing elements and at least one port of the N ports of the second side of the 1 x N integrated-optic waveguide beam splitter; a polarization-maintaining optical sensing fiber having slow and fast principal axes and having a first end coupled to the first port of the integrated-optic waveguide beam splitter and a second end connected to a reflector, wherein at least one of the M polarizing elements is configured to receive a light signal from a light source, such that the light signal is sent through one of the second ports to the polarization-maintaining optical sensing fiber, wherein the M polarizing elements have polarization directions of 45° ($\pm$15°) or -45° ($\pm$15°) with respect to the slow axis of the polarization-maintaining optical sensing fiber, wherein a principal axis of the birefringent optical element is oriented at 0° ($\pm$15°) with respect to the slow axis of the polarization-maintaining optical sensing fiber, wherein the birefringent optical element is configured to introduce a birefringent phase delay in a range of (2m -1) $\times$ 90° ($\pm$15°), where m is a positive integer.

Various embodiments may preferably implement the following features:
Preferably, the light source is a broadband light source.
Preferably, the birefringent optical element is arranged between the at least one of the M polarizing elements and at least one port of the N ports of the second side connected being different from the at least one of the M polarizing elements which is configured to receive the light signal from the light source.

The present invention also relates to a fiber-optic sensor for measuring an optical phase shift $\phi$ between two orthogonal polarization modes of a polarization-maintaining optical sensing fiber, the fiber-optic sensor comprising an integrated-optic waveguide beam splitter having a first port at a first side and N second ports at a second side, the first and second side being preferably opposite to each other, N being a positive integer N $\geq$ 2, and the integrated-optic waveguide beam splitter having a splitter plane; M polarizing elements, M being a positive integer M $\geq$ 2, coupled to the second side of the integrated-optic waveguide beam splitter; a birefringent optical element arranged between at least one of the M polarizing elements and at least one port of the N ports of the second side of the 1 x N integrated-optic waveguide beam splitter; a polarization-maintaining optical sensing fiber having slow and fast principal axes and having a first end coupled to the first port of the integrated-optic waveguide beam splitter and a second end connected to a another polarizing element which is connected to a light source, wherein the M polarizing elements have polarization directions of 45° (±15°) or -45° (±15°) with respect to the slow axis of the polarization-maintaining optical sensing fiber, wherein a principal axis of the birefringent optical element is oriented at 0° (±15°) with respect to the slow axis of the polarization-maintaining optical sensing fiber, and wherein the birefringent optical element is configured to introduce a birefringent phase delay in a range of (2m -1) × 90° (±15°), where m is a positive integer, and wherein the another polarizing element has a polarization direction of 45° (±15°) with respect to a principal axis of the polarization-maintaining optical sensing fiber.

Various embodiments may preferably implement the following features:

Preferably, the light source is a broadband light source.

Preferably, the slow axis of the polarization-maintaining optical sensing fiber is oriented at 0° (±15°) or 90° (±15°) with respect to the normal of the splitter plane.

Preferably, the polarization-maintaining optical sensing fiber comprises a first section and a second section.

Preferably, the first and second fiber sections are coupled to each other such that the slow principal axis of the first section is orthogonal to the slow principal axis of the second section.

Preferably, the birefringent optical element is provided in a recess of the integrated-optic waveguide beam splitter.

Preferably, first end of the polarization-maintaining optical sensing fiber is coupled to the first port of the integrated-optic waveguide beam splitter by a first polarization-maintaining fiber lead and a second polarization-maintaining fiber lead.

Preferably, the first and second polarization-maintaining fiber leads provide substantially identical differential optical path differences for the two orthogonal polarization modes.

Preferably, the first and second polarization-maintaining fiber leads are coupled to each other such that the slow principal axis of the first lead is orthogonal to the slow principal axis of the second lead.

Preferably, a principal axis of the first and second polarization-maintaining fiber leads is parallel to a principal axis of the polarization-maintaining optical sensing fiber.

Preferably, the optical phase shift $\phi$ comprises an alternating phase shift term $\theta_0 \sin \omega t$ and a slowly varying phase shift term $\phi_0(t)$ with $\theta_0$ being the amplitude of the alternating term and $\omega$ being the angular frequency of the alternating term.

Preferably, the slowly varying phase shift term $\phi_0(t)$ is generated by at least one of: changes in ambient temperature, a thermal transducer body, a heating element, or at least one piezo-electric element attached to the polarization-maintaining optical sensing fiber or to the first or second polarization-maintaining fiber leads.

Preferably, the alternating phase shift term $\theta_0 \sin \omega t$ is generated by alternating fiber strain, in particular alternating longitudinal fiber strain, exerted onto the polarization-maintaining optical sensing fiber.

Preferably, the slowly varying phase shift term $\phi_0(t)$ varies in a range of angles >90°.

Preferably, the first and second fiber sections provide substantially identical optical path differences $\Delta L$ for the two orthogonal polarization modes.

Preferably, the optical path differences $\Delta L$ of the two orthogonal polarization modes of the first and second polarization-maintaining fiber lead and/or of the first and section of the polarization-maintaining optical sensing fiber differ, in particular by an amount $0 < \Delta L < I_c$, with $I_c$ being the coherence length of the light source.

Preferably, the slowly varying phase shift term $\phi_0(t)$ is generated via a change of the wavelength of the light source in addition to changes in ambient temperature.

Preferably, the fiber-optic sensor further comprises a processor configured to determine the optical phase shift $\phi$ from at least one first light signal Si($\phi$) and at least one second light signal Sj($\phi$) returning from the polarization-maintaining optical sensing fiber through at least two of the M polarizing elements.

Preferably, the processor is configured to determine the slowly varying and alternating components of the at least one first light signal Si($\phi$) and the at least one second light signal Sj($\phi$).

Preferably, the processor is configured to determine the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$), wherein the fringe contrast is determined by calibration or from the maxima and minima, Si max, Si min, Sj max, Sj min, of the at least one first light signal Si($\phi$) and the at least one second light signal Sj($\phi$).

Preferably, the optical sensing fiber is attached to at least one piezoelectric transducer element that generates the optical phase shift $\phi$ under the influence of an electric field.

Preferably, the at least one piezoelectric transducer element is made of or comprises crystalline quartz.

Preferably, the piezoelectric transducer element is of disk shape or annular shape.

Preferably, a crystallographic x-direction is aligned orthogonal to a facet of the disk shaped or annular shaped transducer element.

Preferably, the optical fiber is attached to a series of piezo-electric transducer elements configured equidistantly along a path between a high voltage electrode and a ground potential electrode.

Preferably, a crystallographic x-direction of the piezo-electric transducer elements is aligned parallel to said path.

Preferably, the piezo-electric transducer elements are arranged as pairs of piezo-electric transducer elements along the path between the high voltage electrode and the ground potential electrode.

Preferably, a crystallographic x-direction of the first piezo-electric transducer element of a pair of piezo-electric transducer elements is anti-parallel to a crystallographic x-direction of the second piezo-electric transducer element of said pair of piezo-electric transducer elements.

Preferably, the first section of the optical fiber is attached to the first piezo-electric transducer elements of said pairs of piezo-electric transducer elements and the second section of the optical fiber is attached to the second piezo-electric transducer elements of said pairs of piezo-electric transducer elements.

Preferably, the optical phase shift represents the voltage between the high voltage electrode and ground potential electrode.

The present invention also relates to a method of using a fiber-optic sensor according to any one of the aforementioned preferred embodiments, the method comprises determining the optical phase shift $\phi$ from at least one first light signal Si($\phi$) and at least one second light signal Sj($\phi$) returning from the polarization-maintaining optical sensing fiber through at least two of the M polarizing elements.

Various embodiments may preferably implement the following features:

Preferably, the method comprises determining the slowly varying and alternating components of the at least one first light signal Si($\phi$) and the at least one second light signal Sj($\phi$).

Preferably, the method comprises determining the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$), wherein the fringe contrast is determined by calibration or from the maxima and minima, Si max, Si min, Sj max, Sj min, of the at least one first light signal Si($\phi$) and the at least one second light signal Sj($\phi$).

The present invention also relates to a system for measuring an optical phase shift comprising a fiber-optic sensor according to any one of the aforementioned embodiments and at least one piezo-electric transducer element according to any one of the aforementioned embodiments.

The present invention also relates to a fiber-optic sensor for measuring an optical phase shift $\phi$ between a fundamental fiber mode and a first higher order mode of an optical sensing fiber. The fiber-optic sensor comprises an integrated-optic waveguide beam splitter having a first port at a first side and N second ports at a second side, the first and second side being preferably opposite to each other, N being a positive integer $N \geq 2$, and the integrated-optic waveguide beam splitter having a splitter plane; M first polarizing elements, M being a positive integer $M \geq 2$, coupled to the second side of the integrated-optic waveguide beam splitter; a birefringent optical element arranged between at least one of the M first polarizing elements and at least one port of the N ports of the second side of the 1 x N integrated-optic waveguide beam splitter; a polarization-maintaining optical fiber, a second polarizing element, the optical sensing fiber, and a reflector, wherein the polarization-maintaining optical fiber has slow and fast principal axes and having a first end coupled to the first port of the integrated-optic waveguide beam splitter and a second end connected to a first end of the second polarizing element, the second polarizing element has a polarization direction of 45° ($\pm$15°) or -45° ($\pm$15°) with respect to the slow axis of the polarization-maintaining optical fiber and a second end of the second polarizing element connected to a first end of the optical sensing fiber, the optical sensing fiber has slow and fast principal axes, the slow axis of optical sensing fiber has a direction of 0° ($\pm$15°) or 90° ($\pm$15°) with respect to the polarization direction of the second polarizing element and optical sensing fiber has a second end connected to the reflector; wherein at least one of the M first polarizing elements is configured to receive a light signal from a light source, in particular a broadband light source, such that the light signal is sent through one of the second ports to the polarization-maintaining optical fiber, wherein said at least one of the M first polarizing elements, configured to receive a light signal from a light source, has a polarization direction of 0° ($\pm$15°) or 90° ($\pm$15°) with respect to the slow axis of the polarization-maintaining optical fiber, wherein the other M-1 polarizing elements of the M first polarizing elements have polarization directions of 45° ($\pm$15°) or -45° ($\pm$15°) with respect to the slow axis of the polarization-maintaining optical fiber, wherein a principal axis of the birefringent optical element is oriented at 0° ($\pm$15°) with respect to the slow axis of the polarization-maintaining optical fiber, and wherein the birefringent optical element is configured to introduce a birefringent phase delay in a range of $(2m -1) \times 90°$ ($\pm$15°), where m is a positive integer.

The present invention also relates to a fiber-optic sensor for measuring an optical phase shift $\phi$ between a fundamental fiber mode and a first higher order mode of an optical sensing fiber. The fiber-optic sensor comprises an integrated-optic waveguide beam splitter having a first port at a first side and N second ports at a second side, the first and second side being preferably opposite to each other, N being a positive integer $N \geq 2$, and the integrated-optic waveguide beam splitter having a splitter plane; M first polarizing elements, M being a positive integer $M \geq 1$, coupled

to the second side of the integrated-optic waveguide beam splitter; a birefringent optical element arranged between at least one of the M first polarizing elements and at least one port of the N ports of the second side of the 1 x N integrated-optic waveguide beam splitter; a polarization-maintaining optical fiber, the optical sensing fiber, and a third polarizing element, wherein the polarization-maintaining optical fiber has slow and fast principal axes and having a first end coupled to the first port of the integrated-optic waveguide beam splitter and a second end connected to a first end of the optical sensing fiber, the optical sensing fiber has slow and fast principal axes and has a second end connected to the third polarizing element which is connected to a light source, in particular a broadband light source; the third polarizing element has a polarization direction of 0° (±15°), or 90° (±15°) with respect to the slow axis of the sensing fiber, wherein the M polarizing elements have polarization directions of 45° (±15°) or -45° (±15°) with respect to the slow axis of the polarization-maintaining optical fiber; wherein a principal axis of the birefringent optical element is oriented at 0° (±15°) with respect to the slow axis of the polarization-maintaining optical fiber; and wherein the birefringent optical element is configured to introduce a birefringent phase delay in a range of $(2m-1) \times 90°$ (±15°), where m is a positive integer.

Various embodiments may preferably implement the following features:

Preferably, the second end of the polarization-maintaining fiber is connected to a first end of the optical sensing fiber, the slow axis of the polarization-maintaining optical fiber is oriented at 45° (±15°), or -45° (±15°) with respect to the slow axis of the sensing fiber, and the core of the polarization-maintaining optical fiber has a transversal offset with respect to the core of the sensing fiber along the slow axis of the sensing fiber.

Preferably, the fiber-optic sensor further comprises a second polarizing element, wherein a first end of the second polarizing element is connected to the second end of the polarization-maintaining fiber and a second end of the second polarizing element is connected to the first end of the optical sensing fiber. Preferably, the second polarizing element has a polarization direction of 45° (±15°) or -45° (±15°) with respect to the slow axis of the polarization-maintaining optical fiber and of 0° (±15°) with respect to the polarization direction of the third polarizing element. Preferably, the core of the second polarizing element has a transversal offset with respect to the core of the sensing fiber along the slow axis of the sensing fiber.

Preferably, the fiber-optic sensor further comprises a third polarization-maintaining fiber. Preferably, a first end of the third polarization-maintaining fiber is connected to the second end of the polarization-maintaining fiber and a second end of third polarization-maintaining fiber is connected to the first end of the optical sensing fiber. Preferably, the slow axis of the polarization-maintaining optical fiber is oriented at 45° (±15°), or -45° (±15°) with respect to the slow axis of the polarization-maintaining optical fiber and at 0° (±15°) or 90° (±15°) with respect to the slow axis of the sensing fiber. Preferably, the core of the third polarization-maintaining fiber has a transversal offset with respect to the core of the sensing fiber along the slow axis of the sensing fiber.

Preferably, the slow axis of the polarization-maintaining optical fiber is oriented at 0° (±15°) or 90° (±15°) with respect to the normal of the splitter plane.

Preferably, the optical path length difference ΔLs between the fundamental mode and the first higher order mode during a single pass through the optical sensing fiber is larger than the coherence length /c of the light source. It is understood by the skilled person that the tolerances for single pass through the optical sensing fiber is preferably smaller than the coherence length of the light source. It is also understood by the skilled person that if not said otherwise, path length differences are preferably meant as the absolute value of the difference.

Preferably, the birefringent optical element is provided in a recess of the integrated-optic waveguide beamsplitter.

Preferably, the length of the polarization-maintaining optical fiber is configured that the optical path length difference ΔLr of the two orthogonal polarization modes of the polarization-maintaining optical fiber during a single pass through the polarization-maintaining optical fiber is twice the optical path length difference ΔLs of the fundamental mode and the higher order mode during a single pass through the optical sensing fiber.

Preferably, the length of the polarization-maintaining optical fiber is configured that the optical path length difference ΔLr of the two orthogonal polarization modes of the polarization-maintaining optical fiber during a single pass through the polarization-maintaining optical fiber is equal to the optical path length difference ΔLs of the fundamental mode and the higher order mode during a single pass through the optical sensing fiber.

Preferably, the optical sensing fiber comprises a first section and a second section, wherein the first and second fiber sections are preferably coupled to each other such that the respective fundamental fiber modes and first higher order modes are swapped. Preferably, the fundamental mode and first higher order mode accumulate an optical path length difference ΔLs, 1 in the first fiber section and of ΔLs,2 in the second fiber section. Preferably, the length difference of first and second fiber sections is configured that the absolute value of the difference (ΔLs,1 - ΔLs,2) is larger than the coherence length of the light source. It is understood by the skilled person that ΔLs,1 and ΔLs,2 preferably refer to the absolute values of the path length differences.

Preferably, the optical sensing fiber has an elliptical core.

Preferably, the optical sensing fiber is at least one of a Panda fiber, a Tiger fiber or a bowtie fiber.

Preferably, the optical phase shift $\phi$ comprises an alternating phase shift term $\theta_0 \sin \omega t$ and a slowly varying

phase shift term $\phi_0(t)$ with $\theta_0$ being the amplitude of the alternating term and $\omega$ being the angular frequency of the alternating term. Preferably, the slowly varying phase shift term $\phi_0(t)$ is generated by at least one of:

> changes in ambient temperature,
> a thermal transducer body,
> a heating element, or
> at least one piezo-electric transducer element attached to the optical sensing fiber or to polarization-maintaining fiber.

Preferably, slowly varying phase shift term $\phi_0(t)$ varies in a range of angles > 90°.

Preferably, the fiber-optic sensor further comprises a processor configured to determine the optical phase shift $\phi$ from at least one first light signal Si($\phi$) and at least one second light signal Sj($\phi$) returning from at least two of the first M polarizing elements.

Preferably, the processor is configured to determine the slowly varying and alternating components of the at least one first light signal Si($\phi$) and the at least one second light signal Sj($\phi$) and to determine the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$). Preferably, the fringe contrast is determined by calibration or from the maxima and minima, Si max, Si min, Sj max, Sj min, of the at least one first light signal Si($\phi$) and the at least one second light signal Sj($\phi$).

Preferably, the length of polarization-maintaining fiber is selected that $\Delta Lr$ equals $2\Delta Ls$ = abs ($\Delta Ls,1 - \Delta Ls,2$) at the minimum or maximum temperature of operation and wherein the signal processor is configured to determine a temperature from the fringe contrast of the at least one first light signal Si($\phi$) and the at least one second light signal Sj($\phi$).

Preferably, the length of polarization-maintaining fiber is selected that $\Delta Lr$ equals $\Delta Ls$ = abs ($\Delta Ls,1 - \Delta Ls,2$) at the minimum or maximum temperature of operation and wherein the signal processor is configured to determine a temperature from the fringe contrast of the at least one first light signal Si($\phi$) and the at least one second light signal Sj($\phi$).

Preferably, the optical sensing fiber is attached to at least one piezoelectric transducer element that generates the optical phase shift $\phi$ under the influence of an electric field. Preferably, the at least one piezoelectric transducer element is made of or comprises crystalline quartz. Preferably, the piezoelectric transducer element is preferably of disk shape or annular shape. Preferably, a crystallographic x-direction is aligned orthogonal to a facet of the disk shaped or annular shaped transducer element.

Preferably, the optical sensing fiber is attached to a series of piezo-electric transducer elements configured equidistantly along a path between a high voltage electrode and a ground potential electrode. Preferably, a crystallographic x-direction of the piezo-electric transducer elements is aligned parallel to said path. Preferably, the piezo-electric transducer elements are arranged as pairs of piezo-electric transducer elements along the path between the high voltage electrode and the ground potential electrode. Preferably, a crystallographic x-direction of the first piezo-electric transducer element of a pair of piezo-electric transducer elements is anti-parallel to a crystallographic x-direction of the second piezo-electric transducer element of said pair of piezo-electric transducer elements. Preferably, the first section of the optical sensing fiber is attached to the first piezo-electric transducer elements of said pairs of piezo-electric transducer elements) and the second section of the optical sensing fiber is attached to the second piezo-electric transducer elements of said pairs of piezo-electric transducer elements. Preferably, the optical phase shift represents the voltage between the high voltage electrode and ground potential electrode.

The present invention also relates to a device for measuring voltages and/or electric fields in an electric power transmission system comprising a fiber-optic sensor according to any one of the previously described preferred embodiments.

The present invention also relates to a system for measuring an optical phase shift comprising a fiber-optic sensor according to any one of the previously described preferred embodiments and at least one piezo-electric transducer element.

BRIEF DESCRIPTION OF THE DRAWINGS

The subject matter of the invention will be explained in more detail in the following text with reference to preferred exemplary embodiments which are illustrated in the attached drawings, in which:

> FIG. 1 relates to a configuration of a fiber-optic sensor according to an embodiment of the present disclosure.

> FIG. 2 relates to a sensor head according to an embodiment of the present disclosure.

> FIG. 3 relates to embodiments of the arrangement the two set of piezo-electric elements with the opposite positive x-directions according to the present disclosure.

FIG. 4 shows an integrated optic polarization splitter/combiner according to an embodiment of the present disclosure.

FIG. 5 shows the interference light signals according to an embodiment of the present disclosure.

FIG. 6 shows a signal processing flow chart according to an embodiment of the present disclosure.

FIG. 7 shows an integrated optic polarization splitter/combiner according to an embodiment of the present disclosure.

FIG. 8 shows an integrated optic polarization splitter/combiner according to an embodiment of the present disclosure.

FIG. 9 shows an integrated optic polarization splitter/combiner according to an embodiment of the present disclosure.

FIG. 10 shows an integrated optic polarization splitter/combiner according to an embodiment of the present disclosure.

FIG. 11 shows fiber-optic sensor in transmission according to an embodiment of the present disclosure.

FIG. 12 shows a fiber-optic sensor according to an embodiment of the present disclosure.

FIG. 13 shows a fiber-optic sensor according to an embodiment of the present disclosure.

FIG. 14A to C show a fiber-optic sensor in transmission according to an embodiment of the present disclosure.

FIG. 15 shows a fiber-optic sensor in transmission according to an embodiment of the present disclosure.

DETAILED DESCRIPTION OF PREFERRED EMBODIMENTS

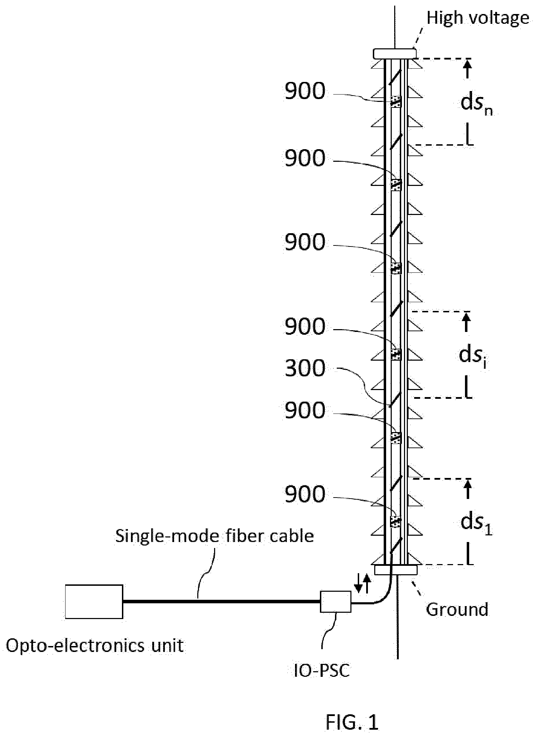

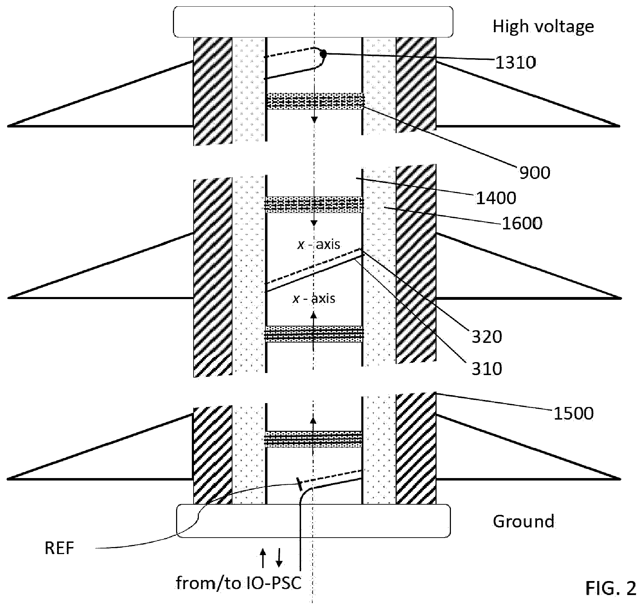

FIGS. 1 and 2 relate to a configuration of a fiber-optic sensor and details of a sensor head (e.g. a primary converter) of the fiber-optic sensor, respectively. The fiber-optic sensor includes an integrated-optic polarization splitter/combiner (IO-PSC) and a polarization maintaining optical sensing fiber 300. As shown in FIG. 1, a path from a ground electrode to a high voltage electrode (e.g. a field integration path or an optical path) consists of n path segments dsi, where i=1, 2, ..., n. For each path segment dsi, a piezo-electric transducer element 900 resides in the middle of each path segment dsi with a longitudinal axis parallel to the integration path. In an example, the piezo-electric elements 900 may consist of quartzes. As shown in FIG. 2, the longitudinal axis of each piezo-electric element 900 coincides with a 2-fold crystallographic axis (crystallographic x-axis)). The alternating electric field modulates a circumferential length L of each piezo-electric element 900 by a converse piezo-electric effect. For the given orientation, a length change $\Delta L$ on each piezo-electric element 900 is proportional to the field component $E_x$ parallel to x-axis shown in FIG. 2. Note that, orthogonal field components have no influence. The length change $\Delta L$ may be expressed as:

$$\Delta L = -(1/2)d_{11}E_xL \qquad (1)$$

where, $d_{11}$ is a relevant piezo-electric coefficient (e.g. $d_{11} = 2.3 \times 10^{-12}$ m/V). Note that $\Delta L$ may be positive or negative depending whether $E_x$ is parallel or anti-parallel to the x-axis. In FIG. 1 and 2, a number of loops of the polarization maintaining optical sensing fiber 300, which includes 2 fiber sections 310 and 320 as shown in FIG. 2, are wrapped with adequate pre-strain on each of the piezo-electric element 900. For example, 5 to 10 fiber loops of the common polarization maintaining optical sensing fiber 300 may be wrapped on each piezo-electric element 900. In an example, the polarization maintaining optical sensing fiber 300 is a birefringent (polarization-maintaining) fiber supporting the two orthogonal polarization modes of the fundamental mode. The modulation of the polarization maintaining optical sensing fiber 300 strain by the piezo-electric elements 900 in the presence of an alternating electric field results in a corresponding modulation of the differential phase of two orthogonal polarization modes of the polarization maintaining optical sensing fiber 300. The optical phase modulation (e.g. an alternating phase shift term) $\theta$ of the two orthogonal polarization modes may be characterized by its amplitude $\theta_0$, frequency $\omega$, and phase $\varphi$:

$$\theta = \theta_0\sin(\omega t + \varphi) \qquad (2)$$

In an example, the phase $\varphi$ is assumed to be 0 and the optical phase modulation $\theta$, which is a measure for the voltage between the high voltage and the ground potential, can be expressed as:

$$\theta = g \sum E_i \cdot ds_i \qquad\qquad (3)$$

where i = 1, 2, ..., n, and g is a conversion factor. That is, the fiber-optic sensor configuration approximates the line integral ∫E · ds, and hence the voltage between the high voltage and ground potential electrodes, by a sum $\sum E_i \cdot ds_i$. Note that, there may be a residual integration error resulted by this approximation and a sensor calibration may be adopted to eliminate the residual integration error for a given field distribution. The number n of path segments dsi is chosen large enough so that the residual integration errors remain within specified limits if the field distribution deviates from the given field distribution of the sensor calibration. The sensitivity of the polarization maintaining optical sensing fiber 300 to strain depends of the fiber parameters and wavelength of operation (i.e., the wavelength of the light signal transmitted in the polarization maintaining optical sensing fiber 300). For example, for phase shift of $2\pi$ between the orthogonal polarization modes, a fiber elongation in the range between 0.1 and 2 mm may be required. In an example, the fiber-optic sensor may be designed to produce an optical phase modulation $\theta$ with an amplitude $\theta_0$ on the order of 10 mrad.

In order to cancel or reduce optical phase modulations caused by mechanical perturbations of the fiber-optic sensor, the positive x-directions of the piezo-electric elements 900 alternate from piezo-electric element 900 to piezo-electric element 900. In an example, one half of the piezo-electric elements 900 have their positive x-axis pointing upward and another half of piezo-electric elements 900 have their positive x-axes pointing downward. As shown in FIG. 2, the directions of the piezo-electric elements 900 alternate from piezo-electric element 900 to piezo-electric element 900, wherein the bottom-most piezo-electric element 900 has its positive x-direction pointing upwards and the top-most piezo-electric element 900 has its positive x-direction pointing downwards. That is, the piezo-electric deformations of the two sets of piezo-electric elements 900 are antiphase. Furthermore, the polarization maintaining optical sensing fiber 300 consists of two identical fiber sections 310 and 320 (solid and dashed lines in FIG. 2) that are joined by a 90°-splice 1310. Under such a condition, the slow principal axis of the fiber section 310 is parallel to the fast principal axis of the fiber section 320 and the differential phase shifts of the orthogonal polarization modes in the fiber sections 310 and 320 are of opposite sign at a given fiber strain. In the example shown in FIG. 2, the fiber section 310 interrogates the piezo-electric elements 900 with the positive x-direction pointing upwards, while the fiber section 320 interrogates the piezo-electric elements 900 with the x-direction pointing downwards. As a result, phase shifts produced by the electric field add up for both sets of piezo-electric elements 900 whereas phase shifts caused by mechanical perturbation cancel out. Note that it is assumed that the mechanical perturbations of neighboring piezo-electric elements 900 with opposite x-directions are of the same magnitude and phases.

In an example, the polarization maintaining optical sensing fiber 300 is operated in a reflection-mode. That is, the fiber section 320 is terminated with a reflector REF, e.g. a reflecting coating, and the orthogonal polarization modes pass the fiber sections 310 and 320 twice. The fiber-optic sensor's sensitivity is doubled, therefore. The total differential group delay that the orthogonal modes accumulate in the fiber sections 310 and 320 is zero due the swapping of the principal axes at the 90°-splice 1310. As a result, coherence of the polarization states is restored after each pass through the fiber sections 310 and 320 even though the light source is of low-coherence.

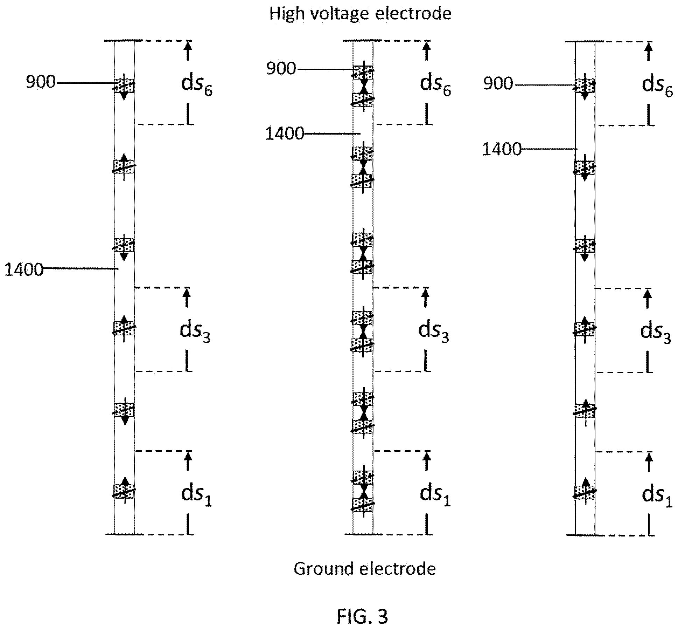

FIG. 3 shows embodiments of the arrangement of the two set of piezo-electric elements 900 with the opposite positive x-directions by using 6 path segments as examples. In the left arrangement shown in FIG. 3, each path segment contains one piezo-electric element 900. The positive and negative x-directions of the piezo-electric elements 900 alternate from path segment to path segment. In middle arrangement shown in FIG. 3, each path segment contains two piezo-electric elements 900 with opposite x-directions. In this example, the distance between the two piezo-electric elements 900 of each path segment may be smaller than a length of each path segment. In the right arrangement shown in FIG. 3, the piezo-electric elements 900 with upward pointing x-directions is arranged in the bottom half of the arrangement and the piezo-electric elements 900 with downward pointing x-directions in the top half of the arrangement. Under such a condition, the 90°-splice 1310 between the two fiber sections 310 and 320 (not shown in FIG. 3) may be between the two sets of piezo-electric elements 900 and the reflector REF is arranged at the high voltage end of the arrangement. In an example, the piezo-electric elements 900 may have a diameter of 30 mm and a thickness of 5 mm.

Note that, the polarization maintaining optical sensing fiber 300 is wrapped onto the piezo-electric elements 900 with an adequate pre-strain. Since a thermal expansion coefficient of the piezo-electric elements 900 is significantly larger than that of the polarization maintaining optical sensing fiber 300, the pre-strain at a room temperature must be sufficiently large so that a minimum strain is still maintained at the smallest operating temperature, e.g., at -40°C. The polarization maintaining optical sensing fiber 300 has a coating that is sufficiently stiff to fully transmit the piezo-electric deformation of the piezo-electric elements 900 onto the polarization maintaining optical sensing fiber 300 over the full temperature range of operation, e.g. between -40 and 85°C. For example, the coatings of the polarization maintaining optical sensing fiber 300 may include coatings from hard acrylate, polyimide, or PEEK (Polyetherether ketone). In an example, the fiber has an outer diameter of 80 μm, rather than the 125-μm-diameter which is more standard in telecommunications, in order to limit bend-induced fiber stress.

In FIG. 2, piezo-electric element end faces of the piezo-electric elements 900 may have glued-on steel disks (not shown) which are configured to connect the piezo-electric elements 900 to dielectric spacer elements 1400 (only one dielectric spacer element 1400 is marked for illustrations) in between the piezo-electric elements 900 since the steel and the piezo-electric element 900 have almost identical thermal expansion coefficients. The steel disks and the dielectric spacer elements 1400 may be connected by springs or other flexible elements to ascertain sufficient mechanical flexibility of the fiber-optic sensor configuration, e.g., in case of deformation of the outer insulator tube by wind forces. Alternatively, the dielectric spacer elements 1400 themselves may be made of a flexible material. Instead of steel disks, disks made from a dielectric material may be chosen. The polarization maintaining optical sensing fiber 300 in between the piezo-electric elements 900 may be loosely wrapped onto the circumference of the dielectric spacer elements 1400 or may be guided through the interior of the, preferably hollow, dielectric spacer elements 1400.

The assembly of piezo-electric elements 900 and dielectric spacer elements 1400 forms a sensing body which is mounted in an slender insulator tube 1500, e.g., with a an inner diameter of 40 mm or 50 mm as illustrated in FIG. 1 and 2. A compressible gel or foam 1600 fills the remaining hollow volume of the insulator tube 1500. The insulator tube 1500 may be equipped with corona rings (not shown) for field steering on the high voltage and/or the ground potential ends of the insulator tube 1500.

In the present disclosure, a method of fiber-optic sensor interrogation, i.e., a method to measure the voltage-induced optical phase modulation θ, is disclosed. In an embodiment, a passive integrated-optic polarization splitter/combiner (IO-PSC) (e.g. the IO-PSC shown in FIG. 1) is used for converting the differential optical phase shift $\phi$ between the two orthogonal polarization modes into changes of light intensity, and an opto-electronics unit (e.g. with photo detectors and a processor) then derives the optical phase modulation θ from the changes of light intensity.

Note that, the total differential optical phase shift $\phi$ of the two orthogonal polarization modes includes, besides the alternating term $\theta = \theta_0 \sin(\omega t + \varphi)$ introduced by the piezo-electric elements, a quasi-static (slowly varying) term $\phi_0$, which can vary as a function of temperature and time over several multiples of $\pi$. For example, the optical phase $\phi$ may be expressed as:

$$\phi = \theta_0 \sin(\omega t + \varphi) + \phi_0.$$

A variation in $\phi_0$ may be caused, e.g., by a variation of birefringence of waveguides in the IO-PSC with the temperature or by a variation in the birefringence in the two fiber sections 310 and 320 if the birefringent phase shifts in the two fiber sections 310 and 320 are not perfectly balanced. In the followings, the IO-PSC and algorithms are functionalized, such that the opto-electronics unit can unambiguously recover the optical phase modulation θ even in the presence of the unknown and varying phase shift (e.g. a slowly varying phase shift term) $\phi_0(t)$. The IO-PSC is a passive device and therefore can be made part of the sensor head. As a result, standard single-mode fibers, rather than polarization-maintaining fibers, can be used between the sensing head and opto-electronics unit in contrast to alternative designs that employ active components such as phase modulators. Therefore, manufacture costs of the fiber-optic sensor can be substantially reduced and the field installation of the fiber-optic sensor can be simplified, since splicing of polarization-maintaining fiber in the field is avoided.

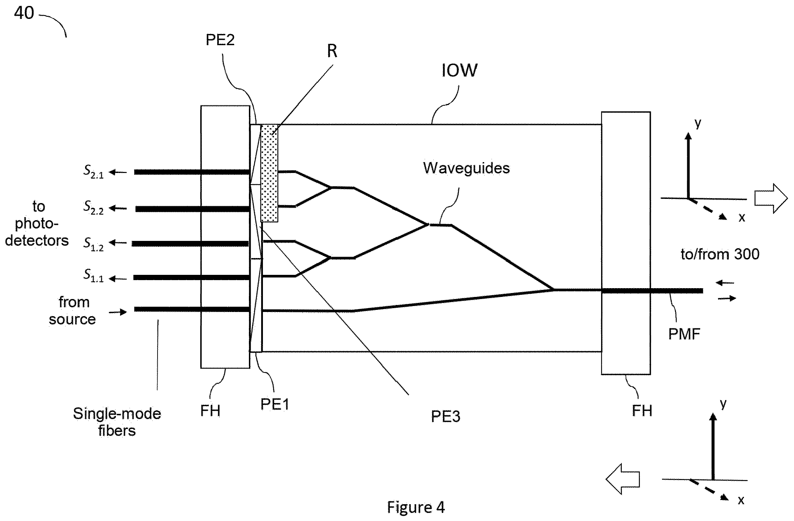

FIG. 4 shows an IO-PSC 40 according to an embodiment of the present disclosure. The IO-PSC 40 may be the IO-PSC shown in FIG. 1. In this example, a broad-band light source (not shown) sends a light signal (e.g. a depolarized light signal) through a single-mode fiber fixed by a fiber holder FH to the IO-PSC 40. The light source may be a superluminescent diode (SLED), e.g., with a center wavelength of 1310 nm and may be part of the opto-electronics unit shown in FIG. 1. In an example, the IO-PSC 40 may be configured at the base (ground potential side) of the fiber-optic sensor configuration shown in FIG. 1. The IO-PSC 40 comprises an integrated optic waveguide beam splitter IOW having a splitter plane and a polarizing element PE1 (e.g. a polarizer platelet) is coupled to a source-side facet of the integrated optic waveguide beam splitter IOW and polarizes the light signal at 45° to the normal of the splitter plane of the integrated optic waveguide beam splitter IOW. After passing through the polarizing element PE1, the light signal enters an input port at the source-side facet of the integrated optic waveguide beam splitter IOW and exits the integrated optic waveguide beam splitter IOW at a sensor-side facet of the integrated optic waveguide beam splitter IOW opposite to the source-side facet. The light signal enters a polarization-maintaining fiber PMF which is fixed by another fiber holder FH coupled to the sensor-side facet of the integrated optic waveguide beam splitter IOW. In this example, a principal axis of the polarization-maintaining fiber PMF is oriented at 0° to the normal of the splitter plane of the integrated optic waveguide beam splitter IOW, so that both orthogonal polarization modes of the polarization-maintaining fiber PMF are exited, e.g., as solid and dashed lines shown in FIG. 4.

The PMF may constitute the fiber section 310 of the polarization maintaining optical sensing fiber 300 or represent an intermediate fiber section between the IO-PSC 40 and the fiber section 310. The integrated optic waveguide beam splitter IOW splits the orthogonal polarization modes returning from the polarization maintaining optical sensing fiber 300 into four detector ports. The orthogonal polarization modes interfere at the polarizing elements PE1, PE2 and PE3 at the source-side facet of the integrated optic waveguide beam splitter IOW. In an example, the polarizing element PE1 has a polarization direction of 45° with respect to the slow axis of the polarization-maintaining fiber PMF, the polarizing element PE2 has a polarization direction of 45° with respect to the slow axis of the polarization-maintaining fiber PMF and the polarizing element PE3 has a polarization direction of -45° with respect to the slow axis of the polarization-maintaining fiber PMF. As a result, there are four interference light signals $S_{1,1}$, $S_{1,2}$, $S_{2,1}$ and $S_{2,2}$ output to the 4 detector ports. A birefringent optical element R (a quarter-wave retarder) with its principal axes parallel and perpendicular to the normal of the integrated optic waveguide beam splitter IOW introduces an extra static phase shift of $(2m-1) \times 90°$ (m is a positive integer) between the orthogonal modes in two of the four detector ports (i.e. the interference light signals $S_{2,1}$ and $S_{2,2}$). In this example, the birefringent optical element R is oriented such that its principal axis is at 0° with respect to a principal axis of the polarization-maintaining fiber PMF. In an example, the birefringent optical element R is mounted in a stress-free manner in a recess of the source-side facet of the integrated optic waveguide beam splitter IOW.

In the following examples, the principal axes of birefringence generated by waveguides in the integrated optic waveguide beam splitter IOW (if there is any birefringence) are assumed to be parallel and orthogonal to the normal of the splitter plane of the integrated optic waveguide beam splitter IOW. In addition, in the present disclosure, angular tolerances for each angle value may be 15°, 10°, 5° or 1°. For example, a principal axis of the birefringent optical element R may be in a range of 0° ($\pm$15°) with respect to a principal of the polarization-maintaining fiber PMF. In a preferable embodiment, a principal axis is in a range of 0° ($\pm$10°) with respect to a principal of the polarization-maintaining fiber PMF. In a more preferable embodiment, a principal axis is in a range of 0° ($\pm$5°) with respect to a principal axis of the polarization-maintaining fiber PMF. In an even more preferable embodiment, a principal axis is at 0°$\pm$1° with respect to a principal axis of the polarization-maintaining fiber PMF.

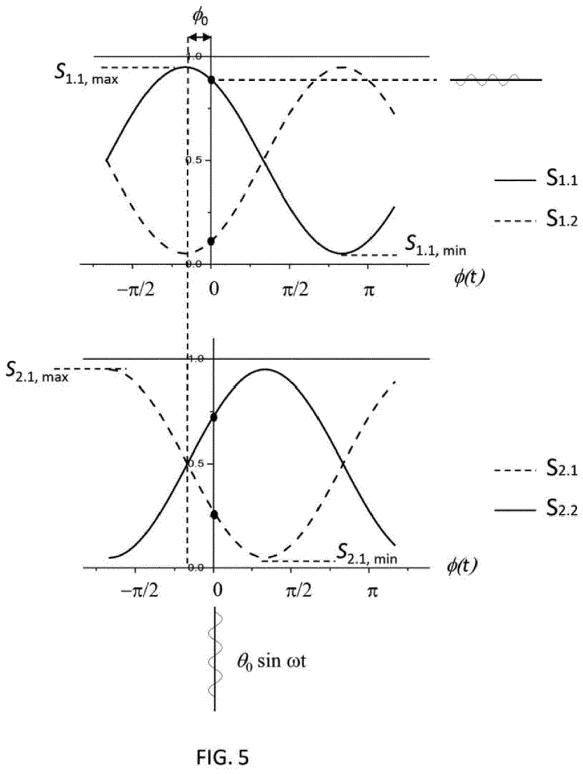

FIG. 5 shows the interference light signals $S_{1,1}$, $S_{1,2}$, $S_{2,1}$ and $S_{2,2}$ according to an embodiment of the present disclosure. In FIG. 5, the interference light signals $S_{1,1}$, $S_{1,2}$, $S_{2,1}$ and $S_{2,2}$ are illustrated as a function of an optical phase shift $\phi$ between the two orthogonal polarization modes at the point of interference.

The interference light signals $S_{1,1}$, $S_{1,2}$ may be expressed as:

$$S_{1,1} = \frac{1}{2} A_{1,1}\left[1 + K_{1,1} \cos(\theta_0 \sin \omega t + \phi_0(t))\right] \qquad (4)$$

$$S_{1,2} = \frac{1}{2} A_{1,2}\left[1 - K_{1,2} \cos(\theta_0 \sin \omega t + \phi_0(t))\right] \qquad (5)$$

Similarly, the interference light signals $S_{2,1}$, $S_{2,2}$ may be expressed as:

$$S_{2,1} = \frac{1}{2} A_{2,1}\left[1 + K_{2,1} \sin(\theta_0 \sin \omega t + \phi_0(t))\right] \qquad (6)$$

$$S_{2,2} = \frac{1}{2} A_{2,2}\left[1 - K_{2,2} \sin(\theta_0 \sin \omega t + \phi_0(t))\right] \qquad (7)$$

where $A_{1,1}$, $A_{1,2}$, $A_{2,1}$ and $A_{2,2}$ are the signal amplitudes which depend on the power of the light source and losses in the opto-electronics unit and $K_{1,1}$, $K_{1,2}$, $K_{2,1}$ and $K_{2,2}$ represent the fringe contrast of the four interference light signals. Ideally, the fringe contrast is equal to unity but in practice may differ from unity in case of unequal amplitude of the interfering polarization modes or only partial coherence. As already mentioned above, $\theta_0$ and $\omega$ are the amplitude and frequency of the phase modulation $\theta$ (i.e., $\theta = \theta_0 \sin \omega t$) generated by the voltage to be measured, and $\phi_0(t)$ is a quasi-static (slowly varying) phase shift between the orthogonal polarization modes. The extra static phase shift (phase bias) introduced by the birefringent optical element R at the detector ports of the interference light signals $S_{2,1}$, $S_{2,2}$ is accounted for by the sine-terms in the equations (6) and (7) instead of the cosine terms in the equations (4) and (5).

The functions (4) to (7) may be expanded and become:

$$S_{1,1} = \frac{1}{2} A_{1,1} \{1 + K_{1,1}[\cos(\theta_0 \sin \omega t) \cos(\phi_0(t)) - \sin(\theta_0 \sin \omega t) \sin(\phi_0(t))]\} \ (8)$$

$$S_{1,2} = \frac{1}{2} A_{1,2} \{1 - K_{1,2}[\cos(\theta_0 \sin \omega t) \cos(\phi_0(t)) - \sin(\theta_0 \sin \omega t) \sin(\phi_0(t))]\} \ (9)$$

$$S_{2,1} = \frac{1}{2} A_{2,1} \{1 + K_{2,1}[\sin(\theta_0 \sin \omega t) \cos(\phi_0(t)) + \cos(\theta_0 \sin \omega t) \sin(\phi_0(t))]\} \ (10)$$

$$S_{2.2} = \frac{1}{2} A_{2.2} \{1 - K_{2.2}[\sin(\theta_0 \sin \omega t) \cos(\phi_0(t)) + \cos(\theta_0 \sin \omega t) \sin(\phi_0(t))]\} \ (11)$$

In general, the amplitude $\theta_0$ is small (e.g., smaller than 0.1 rad) and signal components (or alternating current (AC) components) of the interference light signals $S_{1,1}$, $S_{1,2}$, $S_{2,1}$ and $S_{2,2}$ at the frequency $\omega$ can be expressed as:

$$S_{1,1}^{(\omega)} = -\frac{1}{2} A_{1,1} K_{1,1} \theta_0 \sin(\phi_0(t)) \qquad (12)$$

$$S_{1,2}^{(\omega)} = \frac{1}{2} A_{1,2} K_{1,2} \theta_0 \sin(\phi_0(t)) \qquad (13)$$

$$S_{2,1}^{(\omega)} = -\frac{1}{2} A_{2,1} K_{2.2} \theta_0 \cos(\phi_0(t)) \qquad (14)$$

$$S_{2.2}^{(\omega)} = \frac{1}{2} A_{2.2} K_{2.2} \theta_0 \cos(\phi_0(t)) \qquad (15)$$

Note that, more precisely, an expansion of the equations (4) to (7) by means of Bessel functions yields $2J_1(\theta_0)$ instead merely $\theta_0$ in the equations (8) to (11). However, the difference is negligible when the amplitude $\theta_0$ is sufficiently small.

In addition, direct current (DC) components of the interference light signals $S_{1,1}$, $S_{1,2}$, $S_{2,1}$ and $S_{2,2}$ can be expressed as:

$$S_{1,1}^{(DC)} = \frac{1}{2} A_{1,1} [1 + K_{1,1} \cos(\phi_0(t))] \qquad (16)$$

$$S_{1,2}^{(DC)} = \frac{1}{2} A_{1,2} [1 - K_{1,2} \cos(\phi_0(t))] \qquad (17)$$

$$S_{2,1}^{(DC)} = \frac{1}{2} A_{2,1} [1 + K_{2,1} \sin(\phi_0(t))] \qquad (18)$$

$$S_{2.2}^{(DC)} = \frac{1}{2} A_{2.2} [1 - K_{2.2} \sin(\phi_0(t))] \qquad (19)$$

For further processing, the opto-electronics unit equalizes the two interference light signals of each interference light signal pair (i.e. the interference light signals $S_{1,1}$ and $S_{1,2}$ or the interference light signals $S_{2,1}$ and $S_{2,2}$), to equal amplitudes.

In an embodiment, the first and second interference light signals of each signal pair are normalized by multiplying the first interference light signal with the AC component at frequency $\omega$ of the second interference light signal, and the second interference light signal is normalized by multiplying the second interference light signal with the AC component at frequency $\omega$ of the first interference light signal. For example, the AC and DC components of the normalized interference light signals $S_{1,1}$ and $S_{1,2}$ can be expressed as:

$$S_{1,1}^{(\omega)} = -\tfrac{1}{4} A_{1,1} K_{1,1} A_{1,2} K_{1,2} (\theta_0 \sin \phi_0(t))^2 \qquad (20)$$

$$S_{1,2}^{(\omega)} = \tfrac{1}{4} A_{1,1} K_{1,1} A_{1,2} K_{1,2} (\theta_0 \sin \phi_0(t))^2 \qquad (21)$$

$$S_{1,1}^{(DC)} = \tfrac{1}{4} A_{1,1} A_{1,2} K_{1,2} \theta_0 \sin \phi_0 \left[ 1 + K_{1,1} \cos(\phi_0(t)) \right] \qquad (22)$$

$$S_{1,2}^{(DC)} = \tfrac{1}{4} A_{1,2} A_{1,1} K_{1,1} \theta_0 \sin \phi_0 \left[ 1 - K_{1,2} \cos(\phi_0(t)) \right] \qquad (23)$$

According to the equations (20) to (23), a normalized signal S' which is independent from the optical power terms $A_{1,1}$ and $A_{1,2}$ can be acquired by dividing the difference of the AC components of the interference light signals $S_{1,1}$ and $S_{1,2}$ by the sum of the DC components of the interference light signals $S_{1,1}$ and $S_{1,2}$ :

$$S' = \left( S_{1,1}^{(\omega)} - S_{1,2}^{(\omega)} \right) / \left( S_{1,1}^{(DC)} + S_{1,2}^{(DC)} \right) = -K\theta_0(\sin(\phi_0(t))) \quad (24)$$

where $K=K_{1,1}=K_{1,2}$ is assumed.

The interference light signals $S_{2,1}$ and $S_{2,2}$ may be normalized by similar manners and a normalized signal S" which is independent from the optical power terms $A_{2,1}$ and $A_{2,2}$ can be acquired as:

$$S'' = -K\theta_0\big(\cos(\phi_0(t))\big) \qquad (25)$$

where $K= K_{2,1}=K_{2,2}$ is assumed. Therefore, the unknown phase shift $\phi_0(t)$ can be acquired by:

$$\phi_0(t) = \tan^{-1}(S'/S'') \qquad (26)$$

On the other hands, the values of Ki related to the fringe contrast may be acquired by dividing a difference of the maximum value $S_{i,max}$ and the minimum value $S_{i,min}$ of the interference light signal Si by a sum of the maximum value $S_{i,max}$ and the minimum value $S_{i,min}$ of the interference light signal Si (i=1,1, 1,2, 2,1 and 2,2):

$$K_i = \left( S_{i,max} - S_{i,min} \right) / \left( S_{i,max} + S_{i,min} \right) \qquad (27)$$

The examples of the maximum value and the minimum value of the interference light signal Si (i=1,1, 1,2, 2,1 and 2,2) can refer to FIG. 5. Based on FIG. 5, the maximum value $S_{i,max}$ and the minimum value $S_{i,min}$ may be expressed as:

$$S_{i,max} = \tfrac{1}{2} A_i (1 + K_i) \qquad (28)$$

$$S_{i,min} = \frac{1}{2} A_i (1 - K_i) \qquad\qquad (29)$$

Note that, the values of Ki (i=1,1, 1,2, 2,1 and 2.2) may be determined by calibration measures.

In an example, when the phase shift $\phi_0(t)$ and K are determined, the amplitude $\theta_0$ can be acquired from the equations (24) and (25), and then the voltage which the fiber-optic sensor designed to measure (e.g. the voltage difference between the high voltage and the ground potential) can be acquired. In an example, the phase shift $\phi_0(t)$ is determined based on the equation (24) if the phase shift $\phi_0(t)$ is in a range $(4m - 1)\,\pi/4 < \phi_0(t) \leq (4m+1)\,\pi/4$ (with m being an integer); and the phase shift $\phi_0$ is determined based on the equation (25)) if the phase shift $\phi_0(t)$ is in a range $(4m + 1)\,\pi/4 < \phi_0(t)$ $\leq (4m+3)\,\pi/4$ (with m being an integer). That is, if the absolute value of $\cos(\phi_0(t))$ is between $\dfrac{1}{\sqrt[2]{2}}$ and 1, the phase shift $\phi_0(t)$ is determined based on the equation (24); and if the absolute value of $\sin(\phi_0(t))$ is between $\dfrac{1}{\sqrt[2]{2}}$ and 1, the phase shift $\phi_0(t)$ is determined based on the equation (25).

In order to prevent random switching between the two regimes at times when $\phi_0(t)$ is near the boundaries (i.e. $(4m - 1)\,\pi/4$ or $(4m + 1)\,\pi/4$), appropriate dead zones may be appropriately designed around the boundaries. In an example, if the phase shift $\phi_0$ enters a dead zone from one side of the boundary, the method of determining the phase shift $\phi_0(t)$ is switched only when phase shift $\phi_0(t)$ leaves the dead zone at the opposite side of the boundary and is not switched when the phase shift $\phi_0(t)$ leaves the dead zone at the side of entering. In an example, the width of the dead zones may be chosen, e.g., as 5° or 10°.

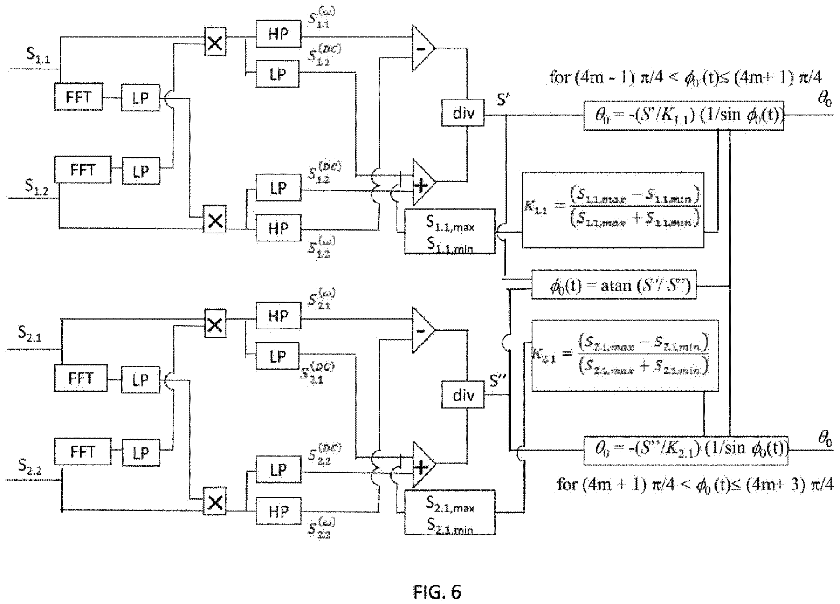

According to different design concepts, various processes of acquiring the phase modulation $\theta_0$ can be implemented based on the equations (4) to (27). FIG. 6 shows a signal processing flow chart according to an embodiment of the present disclosure. For example, the AC components at frequency $\omega$ of the interference light signals $S_{1,1}$, $S_{1,2}$, $S_{2,1}$ and $S_{2,2}$ used for the normalization of the interference light signals are extracted by passing a fast Fourier transform functional block FFT and a low pass filter LP. The low pass filter LP, e.g., with a cutoff frequency of 1 Hz, is configured to average the filtered signals over a certain time period for better stability. However, other concepts such as a bandpass filter or a lock-in technique could be applied. Note that, HP represents a high pass filter HP.

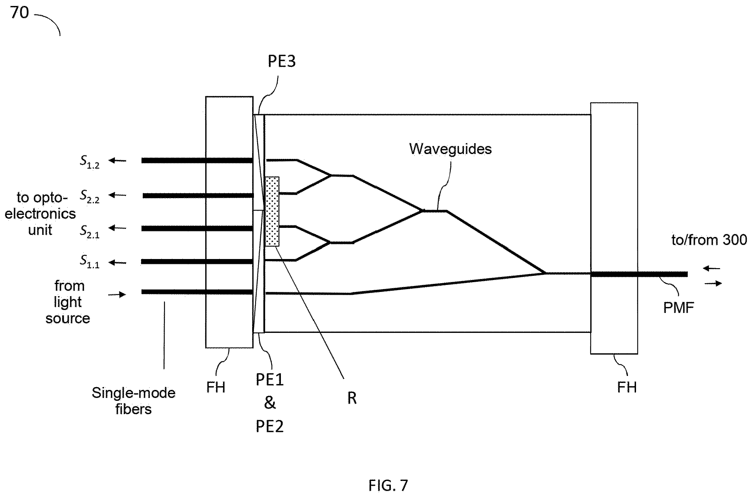

FIG. 7 shows an example of an IO-PSC 70 according to an embodiment of the present disclosure. The IO-PSC 70 is similar to the IO-PSC 40, thus the components with the similar functions use the same symbols. In comparison with the IO-PAC 40, the IO-PSC 70 changes the configurations of the polarizing elements PE1, PE2, PE3 and the birefringent optical element R. Under such a condition, the polarizing elements PE1 and PE2 can be realized by single polarizing element.

In details, the birefringent optical element R changes to be configured to the middle of the detector ports. Because the configurations of the polarizing elements PE1, PE2, PE3, the birefringent optical element R, the polarization-maintaining fiber PMF are the same with those of the IO-PSC 40, the sequence of the signals of the detector ports becomes $S_{1,2}$, $S_{2,2}$, $S_{2,1}$ and $S_{1,1}$ from top to bottom.

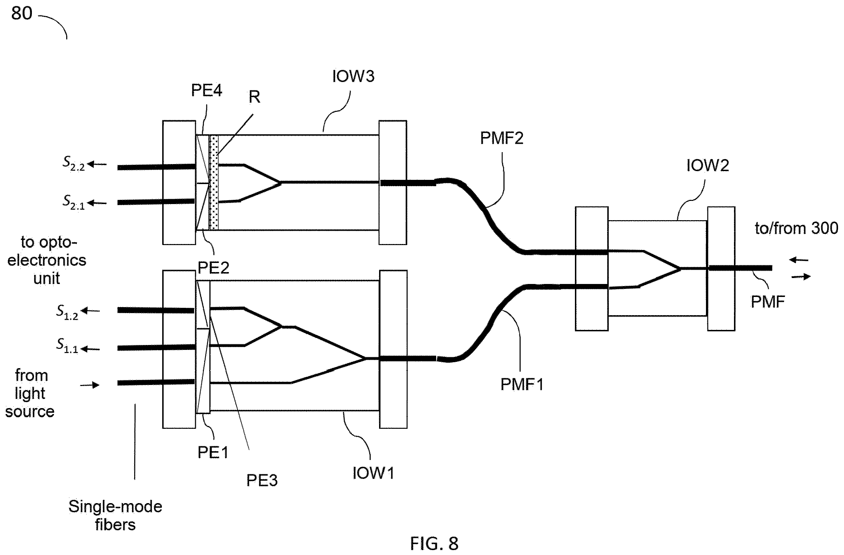

FIG. 8 shows an IO-PSC 80 according to an embodiment of the present disclosure. The IO-PSC 80 is similar to the IO-PSC 40, thus the components and signals with the similar functions use the same symbols. In this embodiment, multiple integrated-optic waveguide beam splitters IOW1, IOW2 and IOW3 are used. Under such a condition, polarization-maintaining fibers PMF1 and PMF2 are added to transmit and/or receive the light signal between the integrated-optic waveguide beam splitters IOW1 and IOW2 or between the integrated-optic waveguide beam splitters IOW2 and IOW3. In addition, a polarizing element PE4 with the same configurations of the polarizing element PE3 is coupled to the birefringent optical element R.

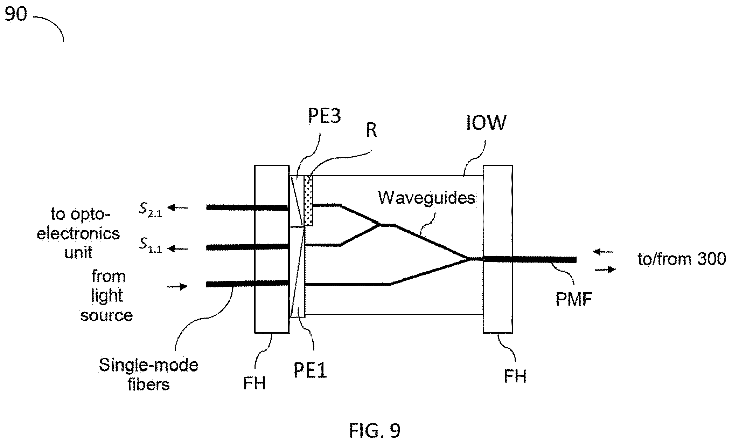

FIG. 9 shows an IO-PSC 90 according to an embodiment of the present disclosure. The IO-PSC 90 is similar to the IO-PSC 40 shown in FIG. 4, thus the components and signals with the similar functions use the same symbols. Different from the IO-PSC 40, the IO-PSC 90 has 2 detector ports corresponding to the interference light signals $S_{1,1}$ and $S_{2,1}$. Under such a condition, the IO-PSC 90 changes to have 2 polarizing element PE1 and PE3. The configurations of the polarizing elements PE1, PE3, the birefringent optical element R, the phase-maintaining fiber PMF are the same with those of the IO-PSC 40.

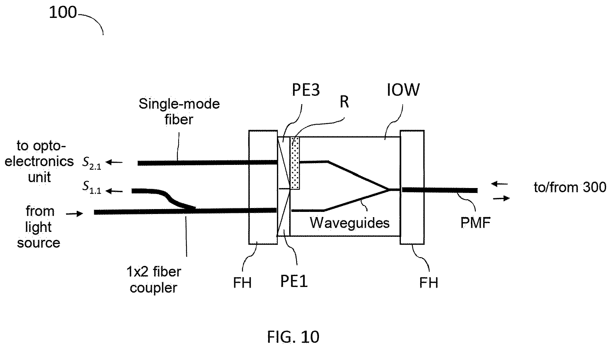

FIG. 10 shows an IO-PSC 100 according to an embodiment of the present disclosure. The IO-PSC 100 is similar to IO-PSC 90, thus the components and signals with the similar functions use the same symbols. In comparison with the IO-PSC 90, the single-mode fiber of the IO-PSC 100 for connecting to the light source includes a 1x2 fiber coupler for outputting the interference light signal $S_{1,1}$. The configurations of the polarizing elements PE1, PE3, the birefringent optical element R, the phase-maintaining fiber PMF are the same with those of the IO-PSC 40.

In the embodiments shown in FIGS. 9 and 10, only the interference light signals $S_{1,1}$ and $S_{2,1}$ are output to the opto-electronics unit (i.e., the photo detectors). Under such a condition, the method of normalizing the interference light signals $S_{1,1}$ and $S_{2,1}$ by the AC components of the interference light signals $S_{1,2}$ and $S_{2,2}$ can not be applied. In an example, the interference light signals $S_{1,1}$ and $S_{2,1}$ are normalized by averages $S_{1,1,av}$ and $S_{2,1,av}$ of the interference light signals $S_{1,1}$ and $S_{2,1}$ and the averages $S_{1,1,av}$ and $S_{2,1,av}$ may be expressed as:

$$S_{1,1,av} = \frac{1}{2}\left(S_{1,1,max} + S_{1,1,min}\right) \qquad (30)$$

$$S_{2,1,av} = \frac{1}{2}\left(S_{2,1,max} + S_{2,1,min}\right) \qquad (31)$$

Where, the maximum values $S_{1,1,max}$ and $S_{2,1,max}$ and the minimum values $S_{1,1,min}$ and $S_{2,1,min}$ may be acquired based on the equations (28) and (29). Hence, the averages $S_{1,1,av}$ and $S_{2,1,av}$ become:

$$S_{1,1,av} = \frac{1}{2}A_{1,1} \qquad (32)$$

$$S_{2,1,av} = \frac{1}{2}A_{2,1} \qquad (33)$$

In an example, the AC components at frequency ω of the interference light signals S1,1 and S2,1 normalized by the averages $S_{1,1,av}$ and $S_{2,1,av}$, may be expressed as:

$$S_{1,1}^{(\omega)} = -\frac{1}{2}K_{1,1}\theta_0 \sin\phi_0(t) \qquad (34)$$

$$S_{2,1}^{(\omega)} = -\frac{1}{2}K_{2,1}\theta_0 \cos\phi_0(t) \qquad (35)$$

Based on the equations (34) and (35), the values of Ki, $\phi_0(t)$ and $\theta_0$ may be determined by similar manners of the aforementioned method.

In an embodiment, the maximum value $S_{i,max}$ and the minimum value $S_{i,min}$ of the interference light signal Si (i=1, 1, 1.2, 2.1 or 2.2) may be required to be recorded. Under such a condition, the phase shift $\phi_0(t)$ must frequently vary within a range of at least 180° such that the maximum value $S_{i,max}$ and the minimum value $S_{i,min}$ can be recorded with sufficient frequency.

In an embodiment, the fiber sections 310 and 320 are chosen with different lengths, i.e., different modal path differences ΔL, for acquiring the phase shift $\phi_0(t)$ with sufficiently large variations. Under such a condition, temperature-dependent variations in the phase shifts, $\phi_{01}(t)$ and $\phi_{02}(t)$ of the two fiber sections 310 and 320 are then no longer fully balanced so that the total offset, i.e., $\phi_0(t)$, varies with temperature. Therefore, the maximum value $S_{i,max}$ and the minimum value $S_{i,min}$ can be recorded with sufficient frequency if the fiber sections 310 and 320 are exposed to varying environmental temperature.

In an embodiment, the fiber sections 310 and 320 having the same fiber lengths and several loops of one of the fiber sections 310 and 320 are wrapped onto a disk or cylinder, e.g., made from aluminum. The changes in the phase shift $\phi_0$ of the fiber section wrapped onto the aluminum disk or cylinder at changing ambient temperature become significantly larger, so as to acquire the large variation in the total phase shift $\phi_0$. Furthermore, changes in the IO-PSC waveguide birefringence, if any, give rise to variations in the phase shift $\phi_0(t)$.

In an embodiment, the variation in the phase shift $\phi_0$ can be enhanced by heating one of the fiber sections 310 and 320 (or the aforementioned metal disk with fiber) from the ambient temperature to a certain maximum temperature (e.g., 65 °C) by means of heating foils or other heating means with subsequent passive cooling back to the ambient temperature. In an example, the means for changing the temperature include Peltier coolers. In an example, the phase shift $\phi_0$ varies in a range of angles > 180° according to the changes of the ambient temperature in a temperature range of operations, e.g., the range between -40°C and 85°C.

In an embodiment, the variation in the phase shift $\phi_0$ may be achieved by wrapping one of the fiber sections 310 and 320 onto a tube-like or disk-like transducer, e.g., made from a piezo-electric ceramic (PZT). The phase shift $\phi_0(t)$ may vary with a voltage connected to the PZT transducer. In an example, the voltage driving the PZT transducer can be generated from the power line electric field via a pick-up capacitor.

In an example, the phase shift $\phi_0$ is varied by a modulation of the wavelength $\lambda$ of the source light signal. In this example, the lengths of the two fiber sections 310 and 320 may be different (so that the two fiber sections 310 and 320 have different modal path imbalances) so as to generate a net total path difference $\Delta L_{net} > 0$ between the orthogonal polarization modes. Note that, the net total optical path difference $\Delta L_{net}$ is preferably chosen smaller than the coherence length $l_c$ of the light source (i.e. $0 < \Delta L_{net} < l_c$). A shift in the wavelength $\lambda$ of the source light signal changes the phase shift $\phi_0$ according to:

$$\delta\phi_0(t) = -2\pi(\Delta L_{net}/\lambda^2)d\lambda \qquad (36)$$

The wavelength $\lambda$ can be varied by changing the source temperature by means of the built-in thermo-electric cooler and/or by changing a drive current of the light source (e.g. SLED). In an example of the SLED whose wavelength is 1310 nm, a temperature change of 1°C shifts the center wavelength of the SLED by up to 0.7 nm. If a group delay difference $\Delta L_{net}$ of 40 $\mu$m (about one coherence length) is introduced between the orthogonal polarization modes, a wavelength shift of 25 nm shifts the phase shift $\phi_0(t)$ over a range of about 3.5 rad (the corresponding source temperature span is about 36 °C). Note that, a change in temperature of the light source also changes the output power of the light source.

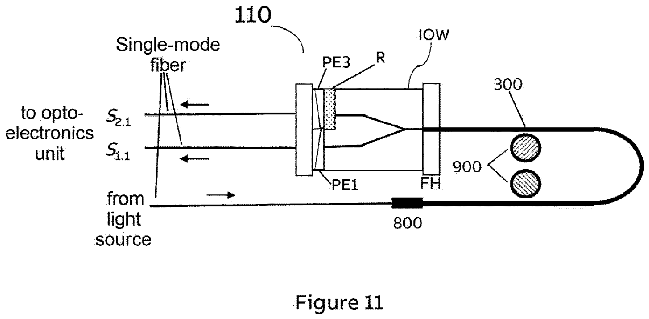

FIG. 11 shows fiber-optic sensor in transmission comprising an IO-PSC 110 according to an embodiment of the present disclosure. The fiber-optic sensor in transmission comprises an integrated-optic waveguide beam splitter IOW having a first port at a first side and two second ports at a second side. Two polarizing elements PE1 and PE3 are coupled to the second side of the integrated-optic waveguide beam splitter IOW. The second side has two single-mode fibers connected which are connected to the opto-electronics unit. A birefringent optical element R is arranged between the polarizing element PE3 and one port of the second side of the integrated-optic waveguide beam splitter IOW. A polarization-maintaining optical sensing fiber 300 having slow and fast principal axes has its first end coupled to the first port of the integrated-optic waveguide beam splitter IOW. A second end of the polarization-maintaining fiber 300 is connected to another polarizing element 800 which is connected to the light source, in this embodiment a broadband light source.

The polarizing element PE3 has a polarization direction of 45° or -45° with respect to the slow axis of the polarization-maintaining optical sensing fiber 300 whereas the polarizing element PE1 has a polarization direction of 45° with respect to the slow axis of the polarization-maintaining optical sensing fiber 300.

According to the embodiment shown in FIG. 11, a principal axis of the birefringent optical element R is oriented at 0° with respect to the slow axis of the polarization-maintaining optical sensing fiber 300. The birefringent optical element R introduces a birefringent phase delay in a range of $(2m -1) \times 90° (\pm 15°)$, where m is a positive integer. The another polarizing element 800 has a polarization direction of 45° with respect to the principal axis of the polarization-maintaining optical sensing fiber 300. In this embodiment, the optical sensing fiber 300 is attached to two piezoelectric transducer elements 900 that generate the optical phase shift $\phi$ under the influence of an electric field which then can be measured by the fiber-optic sensor according to the embodiment of FIG. 11.

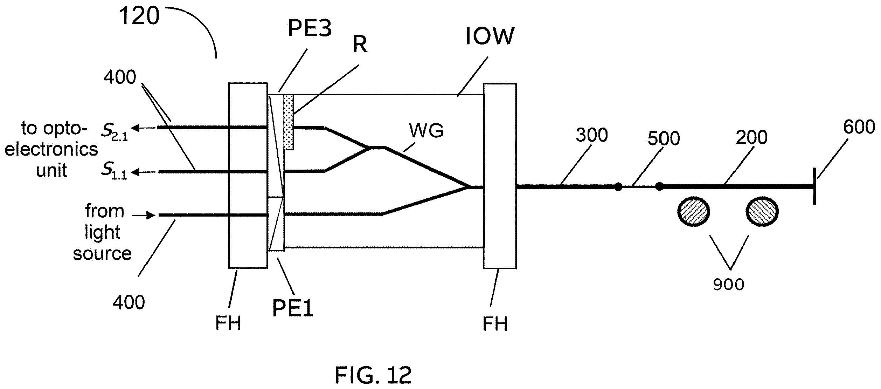

FIG. 12 shows a fiber-optic sensor according to an embodiment of the present disclosure. Instead of using a polarization-maintaining optical fiber 300 as the optical sensing fiber, a fiber 200 that supports at the wavelength of operation the two spatial modes LP01 and LP11 even (fundamental fiber mode and first higher order mode, respectively), e.g. an elliptical-core 2-mode fiber, is used. The 2-mode fiber 200 is part of a white light interferometer with a polarization-maintaining optical fiber 300 acting as the receiving interferometer. An IO-PSC 120 again serves to generate two signals at quadrature (or two pairs of anti-phase signals at quadrature).

A sensing fiber 200 with two spatial modes may be advantageous under certain condition as mode coupling in the presence of external disturbances is reduced compared to a polarimetric sensing fiber that works with two orthogonal polarization states of the fundamental mode as in the embodiments shown above. Otherwise negligible mode coupling is of particular importance if many fiber loops (e.g., dozens of loops in total) are wound on the transducer crystals 900. The reason for reduced mode coupling in 2-mode fibers is that the difference in the effective refractive indices of the modes is larger by one to two orders of magnitude than the index difference of the orthogonal polarization states of the fundamental mode. However, unlike the optical fiber 300, a 2-mode fiber 200 is not immediately compatible with interrogation by means of a polarization splitter, e.g. an IO-PSC.

Therefore, it also an object of the present disclosure to combine a 2-mode fiber and a polarization splitter.

According to this embodiment, a broad-band light source (not shown) sends a light signal (e.g. a depolarized light signal) through a single-mode fiber 400 fixed by a fiber holder FH to the IO-PSC 120. The light source may be a superluminescent diode (SLED), e.g., with a center wavelength of 1310 nm and may be part of the opto-electronics unit (not shown in FIG. 12). The polarizing element PE1 at the source side facet of the IO-PSC 120 polarizes the light parallel to a principal axis of a polarization-maintaining fiber 300 coupled to the sensor head side facet of the IO-PSC 120. Preferably, that principal axis (and hence the PE1 polarization direction) is parallel to the normal of the plane of the splitter waveguides of the IO-PSC 120. At the far end of the polarization-maintaining fiber 300, the light enters through a so-called "45°-splice" a polarizing element 500, e.g. a polarizing fiber, the polarization direction of which is at 45° to a principal axis of the polarization-maintaining fiber 300. Alternative to a polarizing fiber, a polarizer with PM fiber pigtails may be used as polarizing element 500. The polarizing element 500 is connected to an elliptical core 2-mode sensing fiber 200 via a 0°-splice (or 90°-splice) with a lateral offset along the major principal axis of the 2-mode sensing fiber 200. An elliptical-core fiber like the 2-mode sensing fiber 200 supports in a certain wavelength window below the cut-off wavelength of the first higher order mode exclusively the fundamental mode LP01 and the first higher order mode LP11 even. The splice offset is preferably chosen such that the two modes are exited with about equal amplitudes, and the polarization direction is aligned either along the major axis of the 2-mode fiber (0°-splice, x-polarization) or along the minor axis (90°-splice, y-polarization). After a roundtrip through the sensing fiber 200 with the light being reflected at the reflector 600, the two modes couple again to the fundamental mode of the polarizing element 500. At the 45°splice, the light splits into the orthogonal polarization states of the receiving polarization-maintaining fiber 300. Finally, the IO-PSC 120 splits the light into two detector channels, similarly like in the embodiment shown in Fig. 4 (where the light is split into four detector channels, though). A quarter-wave retarder R with a principal axis parallel to a principal axis of the polarization-maintaining fiber 300 introduces in one of the two channels a 90°-phase shift between the orthogonal polarization states. In both channels the orthogonal polarization modes interfere at the polarizing element PE3, oriented at 45° to a principal axis of the polarization-maintaining fiber 300. The resulting interference signals, $S_{1.1}$, $S_{2.1}$, are proportional to the sine and cosine of the phase difference $\phi$ of the orthogonal polarization modes (quadrature signals), with $\phi$ being composed of an alternating term, $\theta_0 \sin \omega t$, produced by the applied voltage and a slowly varying (quasi-static) term $\phi_0$ which may change as a function of the ambient temperature: $\phi = \theta_0 \sin \omega t + \phi_0$. For more details on the signals and their demodulation in the signal processor, full reference is made to the above-presented embodiments.

The 2-mode sensing fiber 200 and the polarization-maintaining fiber 300 form a white light interferometer. The LP01 and LP11 even modes of the 2-mode fiber 200 have different group refractive indices, $n_{g,LP01}$ and $n_{g,LP11}$, respectively, and hence accumulate during a single pass through the fiber with length $l_s$ a differential delay $\Delta L_s$ given by

$$\Delta L_s = \text{abs} \left[ (n_{g,LP11} - n_{g,LP01}) \, l_s \right] \qquad (37)$$

and a delay of $2\Delta L_s$ during a full round trip of the light through the sensing fiber 200. It is should be noted that the delay $\Delta L_s$ is significantly larger than the coherence length $l_c$ of the light source: $\Delta L_s \gg l_c$, i.e., the light source and fiber parameters (in particular the fiber length) must be chosen accordingly. Typically, the coherence length of a SLED is about 30 - 40 $\mu$m and the modal group delay per meter of fiber is typically between a few hundred micrometers and several millimeters depending on the particular fiber parameters and wavelength of operation. It should be noted however, that the wavelength window for 2-mode operation in an elliptical-core fiber contains a particular wavelength near the fiber's cut-off wavelength, where the group indices, $n_{g,LP01}$ and $n_{g,LP11}$, are identical and the differential group delay disappears. Hence, operation near that wavelength is preferably avoided. The polarizing element 500 preserves the group delay of the returning light waves, since all light propagates in the fundamental mode of that element, e.g. a polarizing fiber. The polarization-maintaining fiber 300 introduces a further delay $\Delta L_r = \text{abs} \left[ (n_{g,x} - n_{g,y}) l_r \right]$, where $n_{g,x}$, $n_{g,y}$ are the group indices of two orthogonal polarization states and $l_r$ is fiber length. For half of the transmitted light waves, the delay $\Delta L_r$ adds to the delay $2\Delta L_s$ of the sensing fiber 200, while for the other half the delays subtract, i.e., the light waves arriving at the IO-PSC 120 have delays of $2\Delta L_s + \Delta L_r$ and $2\Delta L_s - \Delta L_r$. The length of the polarization-maintaining fiber 300 is now chosen such that $\Delta L_r$ is equal to $2\Delta L_s$. Hence, half of the light waves return with zero delay and interfere coherently, while the other half has a total delay of $4\Delta L_s$ and is incoherent. Note that the maximum fringe visibility $K$ of the two signals $S_{11}$, $S_{21}$ is then 0.5, i.e., the ratio of the interference intensities and constructive and destructive interference is 3 : 1. It should be noted that due to the polarizing element 500 oriented at 45° half of the optical power is lost on the forward path. It also should be noted that the modal group delay $\Delta L_s$ of the 2-mode fiber 200 is slightly polarization dependent. Exemplarily, the delays of x- and y-polarized light differ by 1-2 %.

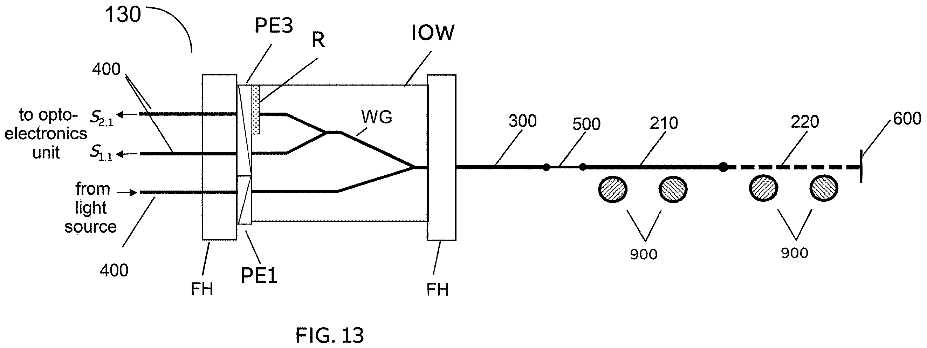

FIG. 13 shows a fiber-optic sensor according to an embodiment of the present disclosure. The fiber-optic sensor is modified compared to the sensor shown in FIG. 12 in that the sensing fiber 200 comprises two sections 210 and 220 with lengths $l_{s,1}$ and $l_{s,2}$, respectively. The two fiber sections 210 and 220 are joined by a 0°-offset splice that swaps the two spatial modes. The major core axes of two fibers sections 210 and 220 at the splice are aligned parallel to each other and the cores are laterally displaced along the major axes in order to achieve the mode swapping. Alternatively to directly joining the two fiber segments, they may be joined by a section of intermediate polarization maintaining fiber, again with offset splices between the polarization maintaining fiber and 2-mode fiber sections 210 and 220. As in the case further above of two sensing fiber sections carrying two orthogonal polarization modes, the use of two 2-mode fiber sections instead of only a single section serves to cancel out modal phase shifts produced by mechanical disturbances.

The single pass group delay in the two 2-mode fiber sections 210 and 220 is given by

$$\Delta L_s = \text{abs} \, [\Delta L_{s,1} - \Delta L_{s,2}] \qquad (38)$$

$$\Delta L_s = \text{abs} \, [ \, (n_{g,LP11} - n_{g,LP01}) \, (l_{s,1} - l_{s,2})] \qquad (39)$$

Here, it is assumed that the fiber sections 210 and 220 are of identical type, i.e., they have the same group indices $n_{g,LP11}$, $n_{g,LP01}$. With the fiber parameters given, the lengths difference $l_{s,1} - l_{s,2}$ must again be chosen such that $\Delta L_s$ is much larger than $l_c$, and the length of the receiving PMF must again be chosen such that $\Delta L_r = 2\Delta L_s$.

It should be noted that in practice the two modes will only partially swap at the offset splice between the fiber sections. This is also true with an intermediate polarization maintaining fiber, in which case only about half of the modal power will be swapped. As a result, the 2-mode fiber sections also introduce a (one way) delay $\Delta L_{s+}$ (equivalent to (37)) given by

$$\Delta L_{s+} = \Delta L_{s,1} + \Delta L_{s,2} \qquad (40)$$

$$\Delta L_{s+} = \text{abs} \, [(n_{g,LP11} - n_{g,LP01}) \, (l_{s,1} + l_{s,2})] = \text{abs} \, [(n_{g,LP11} - n_{g,LP01}) \, l_s] \qquad (41)$$

As a result, there are also light waves with the delays $2\Delta L_{s+} + \Delta L_r$ and $2\Delta L_{s+} - \Delta L_r$ returning to the splitter IO-PSC 130 which however will be incoherent.

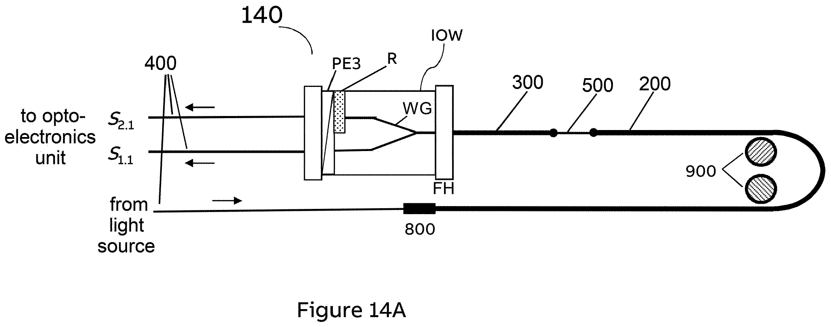

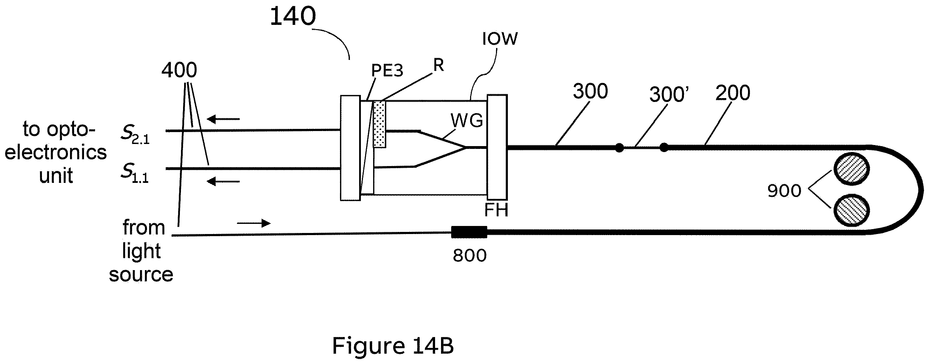

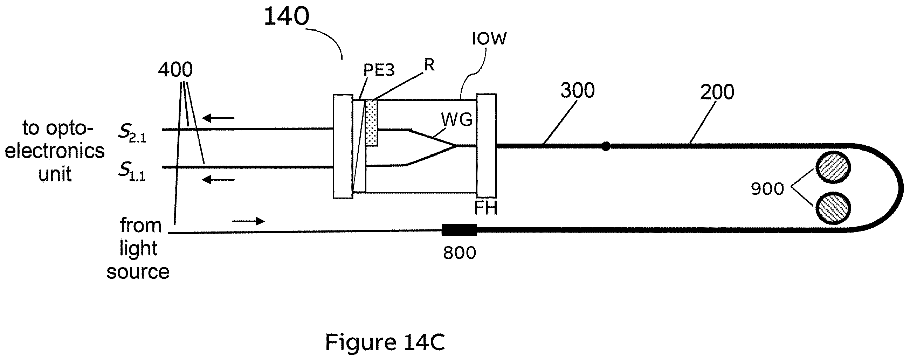

FIG. 14A to C show a fiber-optic sensor in transmission according to an embodiment of the present disclosure. The fiber-optic sensor is similar to the fiber-optic sensor in transmission according to the embodiment shown in FIG.11. In the embodiment shown in FIG. 14A., the light from the source arrives at the 2-mode sensing fiber 200 through a polarizing fiber without passing through the polarization splitter. A polarizing element 800, e.g. a polarizing fiber, replaces the polarizing element PE1 of the embodiment shown in FIG. 12 and 13. At the distant end of the 2-mode fiber 200, the two modes couple into the fundamental mode of the polarizing element 500. Subsequently, the light again splits at a 45°-splice into the orthogonal polarization modes of the receiving PMF. As an alternative instead of the polarizing element 500, a polarization-maintaining fiber 300' can be used as shown in FIG.14B. In this case, the slow axis of the polarization-maintaining optical fiber 300' is oriented at 45° ($\pm$15°), or -45° ($\pm$15°) with respect to the slow axis of the polarization-maintaining optical fiber 300 and at 0° ($\pm$15°) or 90° ($\pm$15°) with respect to the slow axis of the sensing fiber 200. The core of the third polarization-maintaining fiber 300' has a transversal offset with respect to the core of the sensing fiber 200 along the slow axis of the sensing fiber 200. As an alternative to the polarizing element 500 or the polarization-maintaining fiber 300', the sensing fiber 200 can be directly coupled to the polarization fiber 300 as shown in FIG. 14C. In this case, the slow axis of the polarization-maintaining optical fiber 300 is oriented at 45° ($\pm$15°), or -45° ($\pm$15°) with respect to the slow axis of the sensing fiber 200 and the core of the polarization-maintaining optical fiber 300 has a transversal offset with respect to the core of the sensing fiber 200 along the slow axis of the sensing fiber 200.

The IO-PSC 140 is now a $1 \times 2$ splitter and the functions of the splitter's retarder R and the polarizing element PE3 are as in the embodiments shown in FIG. 12 and 13. Since the light passes the 2-mode fiber 200 only once in the embodiments shown in FIG14A to C, the length of the polarization-maintaining fiber 300 should now be chosen such that $\Delta L_r$ equals $\Delta L_s$.

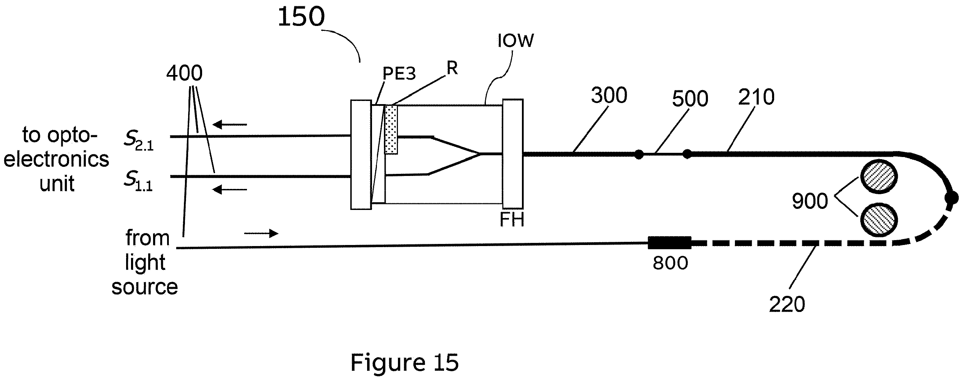

FIG. 15 shows a fiber-optic sensor in transmission according to an embodiment of the present disclosure. The fiber-optic sensor is modified compared to the sensor shown in FIG. 14A to C in that the sensing fiber 200 comprises two sections 210 and 220 with lengths $l_{s,1}$ and $l_{s,2}$, respectively. Thus, $\Delta L_r$ should meet the condition $\Delta L_r = \text{absolute} \, [(n_{g,LP11} - n_{g,LP01})(l_{s,1} - l_{s,2})]$. It is understood by the skilled person that although polarizing element 500 is shown in FIG15 which corresponds to the embodiment shown in FIG. 14A, instead of the polarizing element 500 a polarization-maintaining optical fiber 300' as shown in FIG. 14B or a direct splice as shown in FIG. 14C is possible. A benefit of the transmission configurations shown in FIG. 14A to C and FIG. 15 is that the 50%-power-loss is avoided that occurs at the 45°-splice of the reflective configurations during the forward propagation of the light. Another benefit is a simpler IO-PSC 140 and 150 ($1 \times 2$ splitter instead of $1 \times 3$ splitter). On the other hand, the reflection configurations shown in FIG. 12 and 13 have the benefit that the amplitude $\theta_0$ of voltage-induced phase modulation is doubled for a given number of sensing fiber loops wound on the quartz transducers 900.

EXAMPLES

The circumferential length change $\Delta L$ of the quartz transducer disks in an applied electric field E is given as

$$\Delta L_p = -(1/2) \, d_{11} \, E \, L_p \qquad (6)$$

where $d_{11}$ is the relevant piezo-electric coefficient (2.3 pm/V) and $L_p$ is the circumferential length (perimeter length).

If one assumes an average electric field of 100 kV/m seen by the quartz transducer disks at the rated voltage, a disk diameter of 30 mm, and a total of 100 fiber windings, $\Delta L_p$ equals 1.15 $\mu$m. The fiber length change $\delta l_{2\pi}$ required for a $2\pi$-differential phase shift between the LP01 and LP11 even modes was found to be 140 $\mu$m for x-polarized light (120 $\mu$m for y-polarized light) for an elliptical-core fiber with a core cladding index difference of 0.030 and a core aspect ratio of 2 at a wavelength of 780 nm with the sensing fiber operated in transmission mode. Corresponding numbers for an equivalent fiber designed for operation at 1305 nm would then be about 235 $\mu$m and 200 $\mu$m, respectively. Note that those numbers are halved, if the fiber is operated in reflection mode. With the given parameters, the amplitude $\theta_0$ of the voltage-induced phase modulation at 1310 nm is 4.2 degrees (73 mrad) for a sensing fiber operated in reflection mode with y-polarized light. A hundred fiber windings correspond to a length of the sensing fiber (or a combined length of two fiber sections as shown in FIG. 13 and 15) of about 10 m (in addition, there is some extra length needed for bridging the distance between the transducers).

The modal group index difference of the above mentioned 780 nm 2-mode fiber was found to be 0.0029, i.e., the modal delay $\Delta L_s$ per meter of fiber corresponded to 2.9 mm. One can assume a similar delay for a 2-mode fiber operated at 1305 nm. Hence, a length difference $\Delta l = l_{s,1} - l_{s,2}$ of 10 cm between the two fiber sections as shown in FIG. 13 and 15 would result in a single pass delay $\Delta L_s$ of 290 $\mu$m, which is well sufficient to meet the condition $\Delta L_s \gg l_c$, if one assumes a SLED light source with a coherence $l_c$ of 30 - 40 $\mu$m. The group delay of a typical commercial polarization-maintaining fiber (Panda fiber) is roughly 400 $\mu$m per meter of fiber at 1305 nm. Therefore, the length of the polarization-maintaining fiber receiving fiber should be chosen as 0.725 m, if the 2-mode fiber is operated in transmission mode in order to satisfy the condition $\Delta L_r = \Delta L_s$. In reflection mode, the length difference between the two 2-mode fiber sections can be reduced to 5 cm, if the length of the receiving polarization-maintaining fiber is kept at 0.725 m.

Another consideration is the variation of the delays $\Delta L_r$ and $\Delta L_s$ as a function of temperature. Assuming that $\Delta L_r$ and $\Delta L_s$ are adjusted to equal values at room temperature, different temperature coefficients of $\Delta L_r$ and $\Delta L_s$ will result in a non-zero overall delay $\Delta L = \Delta L_r - \Delta L_s$, and thus a decreasing fringe contrast $K$, if the ambient temperature $T$ deviates from room temperature. One can take advantage of this effect and use the fringe contrast as a measure for the temperature in order to compensate for the variation of the inverse piezo-electric effect with temperature (the relative variation in the coefficient $d_{11}$ is about $-2.0 \times 10^{-4}$ °C$^{-1}$). In this case, one would choose the fiber length difference such that the delay $\Delta L$ is zero not at room temperature but at the maximum or minimum temperature of operation in order to obtain an unambiguous relationship between $K$ and $\Delta L$ (and thus between $K$ and $T$).

Furthermore, $\Delta L$ should remain within about $\pm l_c$ in the temperature range of operation in order to maintain sufficiently high contrast. If the fiber parameters and their temperature coefficients are given, this condition sets an upper limit to the allowed delay $\Delta L_s$ and thus length difference of the 2-mode fiber sections.

A typical temperature coefficient of the differential group delay $\Delta L_s$ of an elliptical-core 2-mode fiber is $5 \times 10^{-5}$ °C$^{-1}$. The temperature coefficient of the delay $\Delta L_r$ of the receiving PM fiber depends on the PM fiber type and may correspond to $-3 \times 10^{-4}$ °C$^{-1}$ in case of an elliptical-core PMF and up to $-10^{-3}$ °C$^{-1}$ for a fiber with stress-induced birefringence such as a Panda fiber. Again assuming $\Delta L_r = \Delta L_s = 290$ $\mu$m at room temperature (corresponding to a length difference of the 2-mode fiber sections of 10 cm in transmission mode) and temperature excursions of $\pm 60$°C, $\Delta L_r$ changes by $\pm 17.4$ $\mu$m and thus stays well within $\pm l_c$ with $l_c = 30$ $\mu$m (neglecting the variation of $\Delta L_s$, as it is very small compared to the change in $\Delta L_r$). In fact, the room temperature delays $\Delta L_r$, $\Delta L_s$ can be enhanced to 500 $\mu$m, while still meeting the condition that the overall delay $\Delta L = \Delta L_r - \Delta L_s$ remains within $\pm l_c$. It is obvious that with an elliptical-core receiving PM fiber instead of a Panda fiber, the overall delay $\Delta L$ changes only by $\pm(5-6)$ $\mu$m, again for a 2-mode fiber length difference of 10 cm (transmission mode), so that there is hardly any fringe contrast change as a function of temperature.

It is understood by the skilled person that instead of a 2-mode sensing fiber having an elliptical core polarization-maintaining fibers such as so-called Panda, Tiger or bowtie fibers may also be operated in a 2-mode regime, even though they may support below their cutoff wavelengths both the even and odd LP11 modes. However, the propagation of the odd LP11 mode can be largely suppressed by appropriately choosing the direction of the splice offset at the fiber entrance.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

LIST OF REFERENCE NUMBERS

**[0138]**

| | |
|---|---|
| 40, 70, 80, 90, 100, 110, 120, 130, 140, 150 | IO-PSC |
| 200 | optical sensing fiber |
| 210, 220 | fiber sections |
| 300 | polarization maintaining optical sensing fiber/ polarization maintaining optical fiber |
| 310, 320 | fiber sections |
| 400 | single-mode fiber |
| 500 | polarizing element |
| 600 | reflector |
| 800 | polarizing element |
| 900 | piezo-electric transducer element |
| 1310 | 90°-splice |
| 1400 | dielectric spacer element |
| 1500 | insulator tube |
| 1600 | compressible gel or foam |
| | |
| R | birefringent optical element |
| IOW1, ..., IOWN | integrated-optic waveguide beam splitter |
| PE1, ..., PEM | polarizing element |
| FH | fiber holder |
| WG | waveguide |

**Claims**

1. A fiber-optic sensor for measuring an optical phase shift $\phi$ between a fundamental fiber mode and a first higher order mode of an optical sensing fiber (200), comprising:

   an integrated-optic waveguide beam splitter (IOW) having a first port at a first side and N second ports at a second side, the first and second side being preferably opposite to each other, N being a positive integer N $\geq$ 2, and the integrated-optic waveguide beam splitter (IOW) having a splitter plane;
   M first polarizing elements (PE1, PE2, ... PEM) M being a positive integer M $\geq$ 2, coupled to the second side of the integrated-optic waveguide beam splitter (IOW);
   a birefringent optical element (R) arranged between at least one of the M first polarizing elements (PE1, PE2, ... PEM) and at least one port of the N ports of the second side of the 1 x N integrated-optic waveguide beam splitter (IOW);
   a polarization-maintaining optical fiber (300), a second polarizing element (500), the optical sensing fiber (200), and a reflector (600),
   wherein

   the polarization-maintaining optical fiber (300) has slow and fast principal axes and having a first end coupled to the first port of the integrated-optic waveguide beam splitter (IOW) and a second end connected to a first end of the second polarizing element (500),
   the second polarizing element (500) has a polarization direction of 45° ($\pm$15°) or -45° ($\pm$15°) with respect to the slow axis of the polarization-maintaining optical fiber (300) and a second end of the second polarizing element (500) connected to a first end of the optical sensing fiber (200), the optical sensing fiber (200) has slow and fast principal axes, the slow axis of optical sensing fiber (200) has a direction of 0° ($\pm$15°) or 90°

($\pm 15°$) with respect to the polarization direction of the second polarizing element (500) and optical sensing fiber (200) has a second end connected to the reflector (600);

wherein at least one of the M first polarizing elements (PE1, PE2, ... PEM) is configured to receive a light signal from a light source, in particular a broadband light source, such that the light signal is sent through one of the second ports to the polarization-maintaining optical fiber (300),

wherein said at least one of the M first polarizing elements (PE1, PE2, ... PEM), configured to receive a light signal from a light source, has a polarization direction of 0° ($\pm 15°$) or 90° ($\pm 15°$) with respect to the slow axis of the polarization-maintaining optical fiber (300),

wherein the other M-1 polarizing elements of the M first polarizing elements (PE1, PE2, ... PEM) have polarization directions of 45° ($\pm 15°$) or -45° ($\pm 15°$) with respect to the slow axis of the polarization-maintaining optical fiber (300),

wherein a principal axis of the birefringent optical element (R) is oriented at 0° ($\pm 15°$) with respect to the slow axis of the polarization-maintaining optical fiber (300), and

wherein the birefringent optical element (R) is configured to introduce a birefringent phase delay in a range of (2m -1) $\times$ 90° ($\pm 15°$), where m is a positive integer.

2. A fiber-optic sensor for measuring an optical phase shift $\phi$ between a fundamental fiber mode and a first higher order mode of an optical sensing fiber (200), comprising:

an integrated-optic waveguide beam splitter (IOW) having a first port at a first side and N second ports at a second side, the first and second side being preferably opposite to each other, N being a positive integer N $\geq$ 2, and the integrated-optic waveguide beam splitter (IOW) having a splitter plane;

M first polarizing elements (PE1, PE2, ... PEM) M being a positive integer M $\geq$ 1, coupled to the second side of the integrated-optic waveguide beam splitter (IOW);

a birefringent optical element (R) arranged between at least one of the M first polarizing elements (PE1, PE2, ... PEM) and at least one port of the N ports of the second side of the 1 x N integrated-optic waveguide beam splitter (IOW);

a polarization-maintaining optical fiber (300), the optical sensing fiber (200), and a third polarizing element (800), wherein

the polarization-maintaining optical fiber (300) has slow and fast principal axes and having a first end coupled to the first port of the integrated-optic waveguide beam splitter (IOW) and a second end connected to a first end of the optical sensing fiber (200),

the optical sensing fiber (200) has slow and fast principal axes and has a second end connected to the third polarizing element (800) which is connected to a light source, in particular a broadband light source;

the third polarizing element (800) has a polarization direction of 0° ($\pm 15°$), or 90° ($\pm 15°$) with respect to the slow axis of the sensing fiber (200),

wherein the M polarizing elements (PE1, PE2, ... PEM) have polarization directions of 45° ($\pm 15°$) or -45° ($\pm 15°$) with respect to the slow axis of the polarization-maintaining optical fiber (300);

wherein a principal axis of the birefringent optical element (R) is oriented at 0° ($\pm 15°$) with respect to the slow axis of the polarization-maintaining optical fiber (300); and

wherein the birefringent optical element (R) is configured to introduce a birefringent phase delay in a range of (2m -1) $\times$ 90° ($\pm 15°$), where m is a positive integer.

3. The fiber-optic sensor according to claim 2, wherein the second end of the polarization-maintaining fiber (300) is connected to a first end of the optical sensing fiber (200), the slow axis of the polarization-maintaining optical fiber (300) is oriented at 45° ($\pm 15°$), or -45° ($\pm 15°$) with respect to the slow axis of the sensing fiber (200), and the core of the polarization-maintaining optical fiber (300) has a transversal offset with respect to the core of the sensing fiber (200) along the slow axis of the sensing fiber (200).

4. The fiber-optic sensor according to claim 2, further comprising a second polarizing element (500), wherein:

a first end of the second polarizing element (500) is connected to the second end of the polarization-maintaining fiber (300) and a second end of the second polarizing element (500) is connected to the first end of the optical sensing fiber (300), wherein

the second polarizing element (500) has a polarization direction of 45° ($\pm 15°$) or -45° ($\pm 15°$) with respect to the slow axis of the polarization-maintaining optical fiber (200) and of 0° ($\pm$15°) with respect to the polarization direction of the third polarizing element (800) and wherein the core of the second polarizing element (500) has a transversal offset with respect to the core of the sensing fiber (200) along the slow axis of the sensing fiber (200).

5. The fiber-optic sensor according to claim 2, further comprising a third polarization-maintaining fiber (300'), wherein:

a first end of the third polarization-maintaining fiber (300') is connected to the second end of the polarization-maintaining fiber (300) and a second end of third polarization-maintaining fiber (300') is connected to the first end of the optical sensing fiber (300), wherein
the slow axis of the polarization-maintaining optical fiber (300') is oriented at 45° ($\pm$15°), or -45° ($\pm$15°) with respect to the slow axis of the polarization-maintaining optical fiber (300) and at 0° ($\pm$15°) or 90° ($\pm$15°) with respect to the slow axis of the sensing fiber (200), and wherein the core of the third polarization-maintaining fiber (300') has a transversal offset with respect to the core of the sensing fiber (200) along the slow axis of the sensing fiber (200).

6. The fiber-optic sensor according to any one of claims 1 to 5, wherein the slow axis of the polarization-maintaining optical fiber (300) is oriented at 0° ($\pm$15°) or 90° ($\pm$15°) with respect to the normal of the splitter plane.

7. The fiber-optic sensor according to any one of claims 1 to 6, wherein
the optical path length difference $\Delta Ls$ between the fundamental mode and the first higher order mode during a single pass through the optical sensing fiber (200) is larger than the coherence length $lc$ of the light source.

8. The fiber-optic sensor according to claim 1, 6 or 7, herein the length of the polarization-maintaining optical fiber (300) is configured that the optical path length difference $\Delta Lr$ of the two orthogonal polarization modes of the polarization-maintaining optical fiber (300) during a single pass through the polarization-maintaining optical fiber (300) is twice the optical path length difference $\Delta Ls$ of the fundamental mode and the higher order mode during a single pass through the optical sensing fiber (200).

9. The fiber-optic sensor according to any one of claims 2 to 7, when at least appended to claim 2, wherein the length of the polarization-maintaining optical fiber (300) is configured that the optical path length difference $\Delta Lr$ of the two orthogonal polarization modes of the polarization-maintaining optical fiber (300) during a single pass through the polarization-maintaining optical fiber (300) is equal to the optical path length difference $\Delta Ls$ of the fundamental mode and the higher order mode during a single pass through the optical sensing fiber (200).

10. The fiber-optic sensor according to any one of claims 1 to 9, wherein the optical sensing fiber (200) comprises a first section (210) and a second section (220), wherein the first and second fiber sections (210, 220) are preferably coupled to each other such that the respective fundamental fiber modes and first higher order modes are swapped, wherein the fundamental mode and first higher order mode accumulate an optical path length difference $\Delta Ls,1$ in the first fiber section (210) and of $\Delta Ls,2$ in the second fiber section (220) and
wherein the length difference of first and second fiber sections (210, 220) is configured that the absolute value of the difference ($\Delta Ls,1 - \Delta Ls,2$) is larger than the coherence length of the light source.

11. The fiber-optic sensor according to any one of claims 1 to 10, wherein the optical sensing fiber (200) has an elliptical core.

12. The fiber-optic sensor according to any of claims 1 to 11,
wherein the optical phase shift $\phi$ comprises an alternating phase shift term $\theta_0 \sin \omega t$ and a slowly varying phase shift term $\phi_0(t)$ with $\theta_0$ being the amplitude of the alternating term and $\omega$ being the angular frequency of the alternating term, and
wherein preferably the slowly varying phase shift term $\phi_0(t)$ is generated by at least one of:

changes in ambient temperature,
a thermal transducer body,
a heating element, or
at least one piezo-electric transducer element (900) attached to the optical sensing fiber (200) or to polarization-maintaining fiber (300).

13. The fiber-optic sensor according to any one of claims 1 to 12, further comprising a processor configured to determine the optical phase shift $\phi$ from at least one first light signal Si($\phi$) and at least one second light signal Sj($\phi$) returning from at least two of the first M polarizing elements (PE1, PE2, .. PEM).

14. The fiber-optic sensor according to claim 13, wherein the processor is configured to determine the slowly varying and alternating components of the at least one first light signal Si($\phi$) and the at least one second light signal Sj($\phi$) and to determine the optical phase shift $\phi$, in particular the alternating phase shift term $\theta_0 \sin \omega t$, based on the slowly varying and alternating components and the fringe contrast of the at least one first light signal Si($\phi$) and the at least one second light signal Sj($\phi$), wherein the fringe contrast is determined by calibration or from the maxima and minima, Si max, Si min, Sj max, Sj min, of the at least one first light signal Si($\phi$) and the at least one second light signal Sj($\phi$).

15. Device for measuring voltages and/or electric fields in an electric power transmission system comprising a fiber-optic sensor according to any one of claims 1 to 14.

16. A system for measuring an optical phase shift comprising a fiber-optic sensor according to any one of claims 1 to 14 and at least one piezo-electric transducer element (900).

FIG. 1

High voltage

1310

900

1400

1600

x - axis

x - axis

320

310

1500

Ground

REF

from/to IO-PSC

FIG. 2

Ground electrode

FIG. 3

Figure 4

FIG. 5

$S_{1.1}$

FFT — LP

$S_{1.2}$

FFT — LP

× — HP — $S_{1.1}^{(\omega)}$

LP — $S_{1.1}^{(DC)}$

LP — $S_{1.2}^{(DC)}$

× — HP — $S_{1.2}^{(\omega)}$

$S_{1.1,max}$
$S_{1.1,min}$

div — $S'$

for $(4m - 1)\,\pi/4 < \phi_0(t) \le (4m+1)\,\pi/4$

$$\theta_0 = -(S'/K_{1.1})\,(1/\sin\phi_0(t))$$

$$K_{1.1} = \frac{(S_{1.1,max} - S_{1.1,min})}{(S_{1.1,max} + S_{1.1,min})}$$

$$\phi_0(t) = \operatorname{atan}(S'/S'')$$

$S_{2.1}$

FFT — LP

$S_{2.2}$

FFT — LP

× — HP — $S_{2.1}^{(\omega)}$

LP — $S_{2.1}^{(DC)}$

LP — $S_{2.2}^{(DC)}$

× — HP — $S_{2.2}^{(\omega)}$

$S_{2.1,max}$
$S_{2.1,min}$

div — $S''$

$$K_{2.1} = \frac{(S_{2.1,max} - S_{2.1,min})}{(S_{2.1,max} + S_{2.1,min})}$$

$$\theta_0 = -(S''/K_{2.1})\,(1/\sin\phi_0(t))$$

for $(4m + 1)\,\pi/4 < \phi_0(t) \le (4m+3)\,\pi/4$

$\theta_0$

FIG. 6

FIG. 7

FIG. 8

FIG. 9

EP 3 951 404 A1

100

PE3 R IOW

Single-mode fiber

to opto-electronics unit $S_{2.1}$

$S_{1.1}$

from light source

1x2 fiber coupler

FH PE1

Waveguides

FH PMF

to/from 300

FIG. 10

Figure 11

FIG. 12

FIG. 13

Figure 14A

Figure 14B

EP 3 951 404 A1

EP 3 951 404 A1

140

400

PE3  R  IOW

to opto-
electronics
unit

$S_{2.1}$

$S_{1.1}$

WG

300

200

from
light
source

FH

800

900

Figure 14C

Figure 15

Europäisches
Patentamt

European
Patent Office

Office européen
des brevets

# EUROPEAN SEARCH REPORT

**Application Number**

EP 20 18 9644

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2015/090448 A1 (ABB TECHNOLOGY AG [CH]) 25 June 2015 (2015-06-25) | 1-7, 10-16 | INV. G01R15/24 |
| A | * page 9, line 24 - line 27; figures 1,8 * * page 29, line 23 - page 31, line 22 * * page 10, line 17 - line 26 * | 8,9 | |
| Y | EP 0 569 700 A2 (ASEA BROWN BOVERI [CH]) 18 November 1993 (1993-11-18) * page 3, line 53 - page 4, line 52; figures 1,5,8 * * page 5, line 18 - line 46 * * page 9, line 9 * | 1-7, 10-16 | |
| Y | DE 41 15 370 A1 (ASEA BROWN BOVERI [CH]) 26 November 1992 (1992-11-26) * page 2, line 33 - line 38; figures 2,4 * * page 3, line 20 - line 37 * | 1-6, 11-16 | |
| A | BOHNERT K ET AL: "Inherent Temperature Compensation of a Dual-Mode Fiber Voltage Sensor with Coherence-Tuned Interrogation", JOURNAL OF LIGHTWAVE TECHNOLOGY, IEEE, USA, vol. 16, no. 4, 1 April 1998 (1998-04-01), XP011029080, ISSN: 0733-8724 * I. INTRODUCTION II. SENSOR PRINCIPLE; figures 1,2 * | 1-16 | TECHNICAL FIELDS SEARCHED (IPC) G01R |
| A | WO 2018/014975 A1 (ABB SCHWEIZ AG [CH]) 25 January 2018 (2018-01-25) * page 25, line 19 - page 26, line 15; figures 1-7,10 * | 1-16 | |

The present search report has been drawn up for all claims

| Place of search | Date of completion of the search | Examiner |
|---|---|---|
| Munich | 14 January 2021 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 18 9644

This annex lists the patent family members relating to the patent documents cited in the above-mentioned European search report.
The members are as contained in the European Patent Office EDP file on
The European Patent Office is in no way liable for these particulars which are merely given for the purpose of information.

14-01-2021

| Patent document cited in search report | | Publication date | Patent family member(s) | | Publication date |
|---|---|---|---|---|---|
| WO 2015090448 | A1 | 25-06-2015 | AU | 2013407826 A1 | 21-07-2016 |
| | | | CN | 106030317 A | 12-10-2016 |
| | | | DK | 3084450 T3 | 15-01-2018 |
| | | | EP | 3084450 A1 | 26-10-2016 |
| | | | ES | 2654679 T3 | 14-02-2018 |
| | | | KR | 20160102023 A | 26-08-2016 |
| | | | US | 2016305984 A1 | 20-10-2016 |
| | | | WO | 2015090448 A1 | 25-06-2015 |
| EP 0569700 | A2 | 18-11-1993 | DE | 4216152 A1 | 18-11-1993 |
| | | | EP | 0569700 A2 | 18-11-1993 |
| | | | JP | 3294376 B2 | 24-06-2002 |
| | | | JP | H0634671 A | 10-02-1994 |
| | | | US | 5343036 A | 30-08-1994 |
| DE 4115370 | A1 | 26-11-1992 | CH | 683471 A5 | 15-03-1994 |
| | | | DE | 4115370 A1 | 26-11-1992 |
| WO 2018014975 | A1 | 25-01-2018 | AU | 2016415342 A1 | 14-03-2019 |
| | | | CN | 109477860 A | 15-03-2019 |
| | | | EP | 3488251 A1 | 29-05-2019 |
| | | | US | 2019154738 A1 | 23-05-2019 |
| | | | WO | 2018014975 A1 | 25-01-2018 |

EPO FORM P0459

For more details about this annex : see Official Journal of the European Patent Office, No. 12/82